# EUROPEAN PATENT APPLICATION

(11) **EP 4 738 427 A1**
(43) Date of publication of application: **06.05.2026**
(21) Application number: 24831999.8
(22) Date of filing: 26.06.2024
(51) Int. Cl.: H01L 21/304

(54) **SUBSTRATE PROCESSING METHOD**

(30) Priority: 29.06.2023 JP 2023106668; 14.05.2024 JP 2024078643
(71) Applicant: SCREEN Holdings Co., Ltd., Kyoto-shi, Kyoto 602-8585 (JP)
(72) Inventor: MAKI, Yusuke, Kyoto-shi, Kyoto 602-8585 (JP); TAKEMATSU, Yusuke, Kyoto-shi, Kyoto 602-8585 (JP); NAKANO, Akiyoshi, Kyoto-shi, Kyoto 602-8585 (JP); TAKAGI, Keisuke, Kyoto-shi, Kyoto 602-8585 (JP); KATO, Masahiko, Kyoto-shi, Kyoto 602-8585 (JP); ISHIZU, Takaaki, Kyoto-shi, Kyoto 602-8585 (JP); IWAKAWA, Yutaka, Kyoto-shi, Kyoto 602-8585 (JP); MIZUKAMI, Daijo, Kyoto-shi, Kyoto 602-8585 (JP); FUJII, Sadamu, Kyoto-shi, Kyoto 602-8585 (JP)
(74) Representative: Kilian Kilian & Partner mbB
(86) International application number: PCT/JP2024/023191
(87) International publication number: WO 2025/005140

(57) **Abstract**

Provided is a technique capable of effectively reducing a collapse ratio of a pattern. A substrate processing method includes a holding step, a liquid supply step, a drying liquid supply step, and a drying step. In the holding step, a substrate having a first main surface on which a pattern is formed and a second main surface on the side opposite to the first main surface is held. In the liquid supply step, process liquid is supplied to the first main surface of the substrate. In the drying liquid supply step, drying liquid is supplied to the first main surface of the substrate after the liquid supply step. In the drying step, the second main surface of the substrate is heated during a predetermined period after the drying liquid supply step, substrate temperature of the first main surface of the substrate is set to be equal to or more than substrate temperature in the drying liquid supply step, and the substrate is dried.

## Description

### TECHNICAL FIELD

The present disclosure relates to a substrate processing method.

### BACKGROUND ART

Conventionally, a single wafer type substrate processing apparatus for processing a substrate has been disclosed (for example, Patent Document 1). In Patent Document 1, the substrate processing apparatus supplies rinse liquid to a substrate, then supplies isopropyl alcohol having a surface tension lower than that of the rinse liquid to the substrate, and then dries the substrate. By this, collapse of a pattern of a substrate during drying is suppressed.

### PRIOR ART DOCUMENT

### PATENT DOCUMENT

Patent Document 1: Japanese Patent Application Laid-Open No. 2015-23182

### SUMMARY

### PROBLEM TO BE SOLVED BY THE INVENTION

However, Patent Document 1 does not consider temperature of isopropyl alcohol. For this reason, a pattern collapse ratio cannot be effectively reduced.

Therefore, an object of the present disclosure is to provide a technique capable of effectively reducing a pattern collapse ratio.

### MEANS TO SOLVE THE PROBLEM

A first aspect is a substrate processing method including a holding step of holding a substrate having a first main surface on which a pattern is formed and a second main surface on a side opposite to the first main surface, a liquid supply step of supplying process liquid to the first main surface of the substrate, a drying liquid supply step of supplying drying liquid to the first main surface of the substrate after the liquid supply step, and a drying step of heating the second main surface of the substrate in a predetermined period after the drying liquid supply step to set a substrate temperature of the first main surface of the substrate to be equal to or more than the substrate temperature in the drying liquid supply step, and drying the substrate.

A second aspect is the substrate processing method according to the first aspect, in which during the predetermined period, the substrate temperature of at least a part of the first main surface of the substrate is equal to or more than a boiling point of the drying liquid.

A third aspect is the substrate processing method according to the first or second aspect, in which in the drying liquid supply step, the second main surface of the substrate is heated with a first amount of heat per unit time, and during the predetermined period in the drying step, the second main surface of the substrate is heated with a second amount of heat per unit time larger than the first amount of heat.

A fourth aspect is the substrate processing method according to any one of the first to third aspects, in which during the predetermined period, a heat medium is supplied to the second main surface of the substrate.

A fifth aspect is the substrate processing method according to the third aspect, in which in the drying liquid supply step, a heat medium obtained by mixing a high-temperature heat medium and a low-temperature heat medium having a temperature lower than a temperature of the high-temperature heat medium is supplied to the second main surface of the substrate, and a mixing ratio of the high-temperature heat medium and the low-temperature heat medium is adjusted to supply the heat medium having a higher temperature than the heat medium in the drying liquid supply step to the second main surface of the substrate at least during the predetermined period in the drying step.

A sixth aspect is the substrate processing method according to the fourth or fifth aspect, in which during the predetermined period, the heat medium having a temperature equal to or more than a boiling point of the drying liquid is supplied to the second main surface of the substrate.

A seventh aspect is the substrate processing method according to any one of the fourth to sixth aspects, in which in the drying liquid supply step, while the heat medium having a temperature equal to or more than a boiling point of the drying liquid is supplied to the second main surface of the substrate, the drying liquid is supplied at a flow rate at which the substrate temperature of the first main surface of the substrate is less than the boiling point.

An eighth aspect is the substrate processing method according to any one of the fourth to seventh aspects, in which the heat medium includes liquid, in the drying liquid supply step, the drying liquid is supplied to the first main surface of the substrate in a state in which a shutoff plate having a facing surface facing the first main surface of the substrate is located at a shutoff processing position, and during the predetermined period in the drying step, in a state where the shutoff plate is moved to a drying position closer to the first main surface than the shutoff processing position, inert gas is supplied from a gas dispense port at a central portion of the shutoff plate toward the first main surface of the substrate.

A ninth aspect is the substrate processing method according to the eighth aspect, in which during the predetermined period, the heated inert gas is supplied to the first main surface of the substrate.

A tenth aspect is the substrate processing method according to the eighth or the ninth aspect, in which in the drying liquid supply step, the inert gas is supplied to the first main surface of the substrate through a gas flow path inside the shutoff plate having an enlarged diameter flow path spreading toward the gas dispense port, and a flow rate of the inert gas is increased while the shutoff plate is moved from the shutoff processing position to the drying position.

An eleventh aspect is the substrate processing method according to the tenth aspect, in which in the drying liquid supply step, the drying liquid is supplied to the first main surface of the substrate in a state where the shutoff plate is located at a first shutoff processing position which is one of the shutoff processing positions, and then the shutoff plate is moved to a second shutoff processing position which is one of the shutoff processing positions and closer to the first main surface of the substrate than the first shutoff processing position while the drying liquid is supplied.

A twelfth aspect is the substrate processing method according to any one of the first to eleventh aspects, in which during the predetermined period in the drying step, the substrate is rotated at a rotation speed higher than a rotation speed of the substrate in the drying liquid supply step.

A thirteenth aspect is the substrate processing method according to any one of the first to twelfth aspects, in which in the drying liquid supply step, the second main surface of the substrate is heated only in subsequent time during drying liquid supply time for supplying the drying liquid.

### EFFECTS OF THE INVENTION

According to the first aspect, the second main surface of the substrate is heated during the predetermined period. For this reason, drying liquid can be evaporated in a state where a surface tension of the drying liquid is smaller and an evaporation rate is higher. Therefore, collapse of a pattern during drying of the first main surface of the substrate can be suppressed.

According to the second aspect, a surface tension of drying liquid during the predetermined period can be further reduced, and an evaporation rate of the drying liquid can be further increased. For this reason, a collapse ratio of a pattern can be further reduced.

According to the third aspect, in the drying liquid supply step, drying liquid is supplied to the first main surface of the substrate while the second main surface of the substrate is heated with a relatively small first amount of heat. For this reason, in a state where drying liquid is supplied, it is possible to suppress increase in a substrate temperature and to suppress boiling of the drying liquid. For this reason, adhesion of particles can be suppressed. On the other hand, during a predetermined period of the drying step, the second main surface of the substrate is heated with a relatively large second amount of heat in a state where drying liquid is not supplied to the substrate. For this reason, an evaporation rate can be further increased while a surface tension of drying liquid in the predetermined time is further reduced. Therefore, a collapse ratio of a pattern can be further reduced.

According to the fourth aspect, the second main surface of the substrate can be easily heated.

According to the fifth aspect, since a mixing ratio is adjusted, temperature of a heat medium supplied to the second main surface of the substrate can be rapidly increased. For this reason, in the drying step, temperature of drying liquid can be raised at an earlier timing. Therefore, a collapse ratio of a pattern can be further reduced.

According to the sixth aspect, in the drying step, an evaporation rate can be further increased while a surface tension of drying liquid is further reduced. Therefore, a collapse ratio of a pattern can be further reduced.

According to the seventh aspect, in the drying liquid supply step, temperature of the first main surface of the substrate can be increased to a temperature closer to a boiling point of drying liquid.

According to the eighth aspect, during the predetermined period, the shutoff plate is located at the drying position close to the substrate. For this reason, an interval between the substrate and the shutoff plate can be narrowed, and a flow rate of inert gas flowing out radially outward from between the substrate and the shutoff plate can be increased. Therefore, it is possible to suppress wraparound of a heat medium from the second main surface to the first main surface via a peripheral edge of the substrate.

According to the ninth aspect, drying liquid can be evaporated in shorter time. For this reason, a collapse ratio of a pattern can be further reduced.

According to the tenth aspect, it is possible to further reduce a collapse ratio of a pattern while adhesion of drying liquid to the shutoff plate is suppressed.

According to the eleventh aspect, immediately before the drying step, the shutoff plate is located at the second shutoff processing position. For this reason, the shutoff plate can be moved to the drying position more quickly. Therefore, the substrate can be dried more quickly, and a collapse ratio of a pattern can be further reduced.

According to the twelfth aspect, drying liquid can be evaporated in shorter time. For this reason, a collapse ratio of a pattern can be further reduced.

According to the thirteenth aspect, power consumption can be reduced.

### BRIEF DESCRIPTION OF DRAWINGS

[FIG. 1] is a plan view schematically illustrating an example of a configuration of a substrate processing apparatus.
[FIG. 2] is a block diagram schematically illustrating an example of an internal configuration of a control unit.
[FIG. 3] is a longitudinal cross-sectional view schematically illustrating an example of a configuration of a processing unit according to a first embodiment.
[FIG. 4] is a flowchart illustrating an example of an operation of the processing unit.
[FIG. 5] is a diagram schematically illustrating an example of a state of the processing unit in each step.
[FIG. 6] is a diagram schematically illustrating an example of a state of the processing unit in each step.
[FIG. 7] is a diagram schematically illustrating an example of a timing chart of the processing unit and a temporal change in temperature of a first main surface of a substrate.
[FIG. 8] is a diagram schematically illustrating an example of a configuration of a substrate heating unit according to a second embodiment.
[FIG. 9] is a diagram schematically illustrating an example of a timing chart of the processing unit according to the second embodiment, a flow rate of a heat medium, and a temporal change of temperature of the heat medium.
[FIG. 10] is a diagram schematically illustrating an example of a timing chart of the processing unit according to a third embodiment and a temperature change of the first main surface of a substrate.
[FIG. 11] is a diagram schematically illustrating an example of a timing chart of the processing unit according to a fourth embodiment, and a temporal change of a flow rate of the heat medium, temperature of the heat medium, and temperature of the first main surface of a substrate.
[FIG. 12] is a flowchart illustrating a first example of an operation of the processing unit according to a fifth embodiment.
[FIG. 13] is a flowchart illustrating a second example of an operation of the processing unit according to the fifth embodiment.
[FIG. 14] is a diagram schematically illustrating a first example of a configuration of a shutoff plate according to a sixth embodiment.
[FIG. 15] is a diagram schematically illustrating an example of a state in which inert gas is dispensed.
[FIG. 16] is a diagram illustrating a first example of a timing chart of the processing unit according to the sixth embodiment.
[FIG. 17] is a diagram schematically illustrating a second example of a timing chart of the processing unit according to the sixth embodiment.
[FIG. 18] is a diagram illustrating an example of a state of the processing unit in a drying liquid supply step.
[FIG. 19] is a diagram illustrating an example of a state of the processing unit in the drying liquid supply step according to the sixth embodiment.
[FIG. 20] is a diagram illustrating a second example of a configuration of the shutoff plate according to the sixth embodiment.

### DESCRIPTION OF EMBODIMENTS

Hereinafter, embodiments will be described in detail with reference to the drawings. Note that, in the drawings, dimensions and the number of units are exaggerated or simplified as necessary for easy understanding. Further, portions having similar configurations and functions are denoted by the same reference numerals, and redundant description will be omitted in the following description.

Further, in description shown below, similar constituent elements are illustrated with the same reference numerals. This similarly applies to their names and functions. Therefore, there is a case where detailed description of them is omitted to avoid duplication.

Further, in description described below, even if ordinal numbers such as "first" or "second" are used, these terms are used for convenience to facilitate understanding of content of the embodiment, and the content of the embodiment is not limited to order or the like that can be caused by these ordinal numbers.

In a case where expressions indicating a relative or absolute positional relationship (for example, "in one direction", "along one direction", "parallel", "orthogonal", "center", "concentric", "coaxial", and the like) are used, the expressions shall not only strictly represent the positional relationship, but also represent a state of being displaced relative to an angle or distance to the extent that a tolerance or a similar function is obtained, unless otherwise specified. In a case where an expression indicating an equal state (for example, "same", "equal", "homogeneous", or the like) is used, unless otherwise specified, the expression not only represents a quantitatively strictly equal state, but also represents a state in which there is a tolerance or a difference in which a similar function can be obtained. In a case where an expression indicating a shape (for example, "quadrangular" or "cylindrical") is used, unless otherwise specified, the expression not only represents the shape geometrically and strictly, but also represents a shape having, for example, unevenness or chamfering within a range in which the same level of effect can be obtained. In a case where the expression "provided with", "exhibiting", "comprising", "including", or "having" one component is used, the expression is not an exclusive expression excluding the presence of other components. In a case where the expression "at least any one of A, B, and C" is used, the expression includes only A, only B, only C, any two of A, B and C, and all of A, B and C.

### <First embodiment>

### <Overall configuration of substrate processing apparatus>

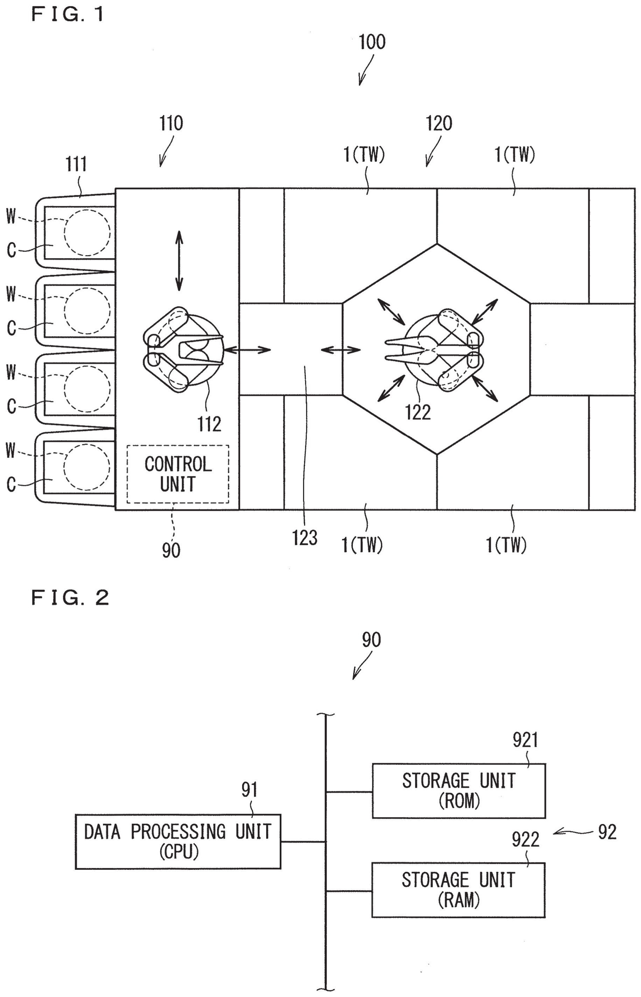

FIG. 1 is a plan view schematically illustrating an example of a configuration of a substrate processing apparatus 100. The substrate processing apparatus 100 is a single wafer type processing apparatus that processes substrates W one by one.

The substrate W is, for example, a semiconductor wafer, a liquid crystal display substrate, an organic electroluminescence (EL) substrate, a flat panel display (FPD) substrate, an optical display substrate, a magnetic disk substrate, an optical disk substrate, a magneto-optical disk substrate, a photomask substrate, or a solar cell substrate. The substrate W has a thin flat plate shape having a first main surface Wa and a second main surface Wb. The second main surface Wb is a surface opposite to the first main surface Wa. Hereinafter, it is assumed that the substrate W is a semiconductor wafer. The substrate W has, for example, a disk shape. A diameter of the substrate W is, for example, about 300 mm, and a thickness of the substrate W is, for example, about 0.5 mm or more and about 3 mm or less. A pattern is formed on a main surface of the substrate W. The pattern here includes, for example, at least one of a wiring pattern, an electrode pattern, a semiconductor pattern, and an insulating pattern. An aspect ratio of the pattern is, for example, 5 or more and 500 or less. A pattern width is, for example, 3 nm or more and 50 nm or less. Such a high aspect ratio pattern is likely to collapse.

In the example of FIG. 1, the substrate processing apparatus 100 includes an indexer block 110, a processing block 120, and a control unit 90. The processing block 120 is a portion that mainly processes the substrate W, and the indexer block 110 is a portion that mainly transfers the substrate W between the outside of the substrate processing apparatus 100 and the processing block 120.

The indexer block 110 includes a load port 111 and a first transfer unit 112. A substrate container (hereinafter, referred to as carrier) C carried in from the outside is placed on the load port 111. A plurality of the substrates W are accommodated in the carrier C in a state of being arranged at intervals in a vertical direction, for example. In the example of FIG. 1, a plurality of the load ports 111 are arranged.

The first transfer unit 112 is a transfer robot, and can take out the unprocessed substrate W from the carrier C placed on each of the load ports 111. The first transfer unit 112 may also be referred to as an indexer robot. The first transfer unit 112 transfers the unprocessed substrate W taken out from the carrier C to the processing block 120. The processing block 120 can process the unprocessed substrate W. Further, the first transfer unit 112 can receive the processed substrate W from the processing block 120 and transfer the processed substrate W to the carrier C of the load port 111.

In the example of FIG. 1, the processing block 120 includes a plurality of processing units 1 and a second transfer unit 122. The second transfer unit 122 is a transfer robot, and can transfer the substrate W between the first transfer unit 112 and a plurality of the processing units 1. In the example of FIG. 1, the processing block 120 also includes a placement portion 123. The placement portion 123 is, for example, a shelf on which a plurality of the substrates W can be placed in a state of being arranged in the vertical direction. The first transfer unit 112 places the unprocessed substrate W on the placement portion 123. The second transfer unit 122 takes out the unprocessed substrate W from the placement portion 123 and transfers the substrate W to the processing unit 1. The processing unit 1 processes the substrate W. A configuration of the processing unit 1 will be described later. The second transfer unit 122 takes out the processed substrate W from the processing unit 1 and transfers the substrate W to the placement portion 123. The first transfer unit 112 takes out the substrate W from the placement portion 123 and transfers the substrate W to the carrier C of the load port 111.

In the example of FIG. 1, a plurality (for example, four) of the processing units 1 are provided so as to surround the second transfer unit 122 in plan view. The second transfer unit 122 may also be referred to as a center robot. A plurality of the processing units 1 may be stacked in the vertical direction at each position in plan view. That is, a plurality of (four in the drawing) towers TW constituted by a plurality of the processing units 1 stacked in the vertical direction may be provided so as to surround the second transfer unit 122.

The control unit 90 integrally controls the substrate processing apparatus 100. Specifically, the control unit 90 controls the first transfer unit 112, the second transfer unit 122, and the processing unit 1. FIG. 2 is a block diagram schematically illustrating an example of an internal configuration of the control unit 90. The control unit 90 is an electronic circuit, and includes, for example, a data processing unit 91 and a storage unit 92. In the specific example of FIG. 2, the data processing unit 91 and the storage unit 92 are connected to each other via a bus 93. The data processing unit 91 may be, for example, an arithmetic processing unit such as a central processor unit (CPU). The storage unit 92 may include a non-transitory storage unit (for example, a read only memory (ROM)) 921 and a temporary storage unit (for example, a random access memory (RAM)) 922. The non-transitory storage unit 921 may store, for example, a program that defines processing to be executed by the control unit 90. When the data processing unit 91 executes this program, the control unit 90 can execute processing defined in the program. As a matter of course, part or all of processing executed by the control unit 90 may be executed by hardware such as a dedicated logic circuit.

### <Outline of processing unit>

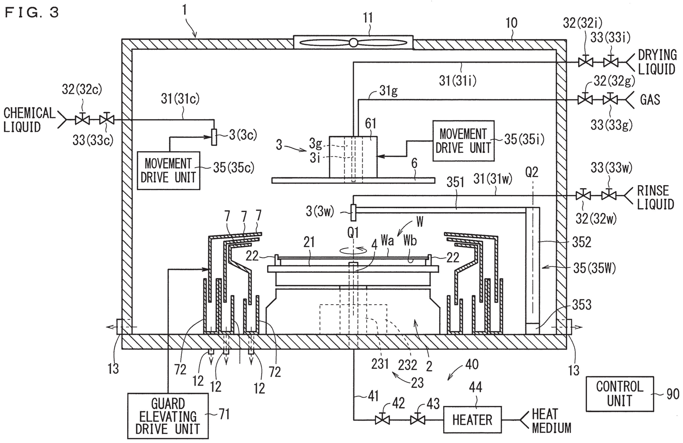

FIG. 3 is a longitudinal cross-sectional view schematically illustrating an example of a configuration of the processing unit 1 according to a first embodiment. Note that all the processing units 1 belonging to the substrate processing apparatus 100 do not need to have the configuration illustrated in FIG. 3. At least one of the processing units 1 of the substrate processing apparatus 100 only needs to have the configuration illustrated in FIG. 3.

The processing unit 1 includes a substrate holding unit 2, at least one nozzle 3, and a substrate heating unit 40.

In the example of FIG. 3, the processing unit 1 is also provided with a chamber 10. The chamber 10 has a box shape, and an internal space of the chamber 10 corresponds to a processing space for processing the substrate W. The chamber 10 is provided with an openable and closable transfer port (not illustrated). The second transport unit 122 transfers the unprocessed substrate W into the chamber 10 through the transfer port, and transfers the processed substrate W out of the chamber 10 through the transfer port.

In the example of FIG. 3, a fan filter unit 11 is provided on a ceiling portion of the chamber 10. The fan filter unit 11 takes in air outside the chamber 10 and cleans the air, and blows the cleaned air into the chamber 10. Activation of the fan filter unit 11 creates a clean air downflow in the chamber 10. In the example of FIG. 3, an upstream end of an exhaust pipe 13 is connected to a lower portion of a side wall of the chamber 10. Gas in the chamber 10 is discharged to the outside through the exhaust pipe 13.

The substrate holding unit 2 is provided in the chamber 10, and rotates the substrate W around a rotation axis Q1 while holding the substrate W in a horizontal posture. The horizontal posture here is a posture in which a thickness direction of the substrate W is along the vertical direction. The rotation axis Q1 is an axis passing through the center of the substrate W and extending along the vertical direction. The substrate holding unit 2 may also be referred to as a spin chuck.

Here, the first main surface Wa of the substrate W on which a pattern is formed faces vertically upward. That is, in the example of FIG. 3, the first main surface Wa of the substrate W held by the substrate holding unit 2 corresponds to an upper surface. The pattern includes, for example, at least one of a wiring pattern, an insulating pattern, and a semiconductor pattern.

In the example of FIG. 3, the substrate holding unit 2 includes a spin base 21, a chuck pin 22, and a rotation drive unit 23. The spin base 21 has a plate-like shape (for example, a disk shape), and is provided in a posture in which a thickness direction of the spin base 21 is along the vertical direction. A plurality of the chuck pins 22 are provided on an upper surface of the spin base 21. A plurality of the chuck pins 22 are provided at equal intervals along a circumferential direction with respect to the rotation axis Q1. A plurality of the chuck pins 22 are provided so as to be displaceable between a holding position and a release position to be described below. The holding position is a position where the chuck pin 22 abuts on a peripheral edge of the substrate W. When a plurality of the chuck pins 22 stop at their holding positions, a plurality of the chuck pins 22 hold the substrate W. In FIG. 3, the chuck pin 22 stopped at the holding position is shown. The release position is a position where each of the chuck pins 22 is separated from the substrate W. When a plurality of the chuck pins 22 stop at their release positions, holding of the substrate W by a plurality of the chuck pins 22 is released. The substrate holding unit 2 also includes a pin drive unit (not illustrated) that displaces the chuck pin 22. The pin drive unit includes, for example, a drive source such as a motor and an air cylinder, and is controlled by the control unit 90.

The rotation drive unit 23 includes a shaft 231 and a motor 232. An upper end of the shaft 231 is connected to a lower surface of the spin base 21, and the shaft 231 extends from a lower surface of the spin base 21 along the rotation axis Q1. The motor 232 is controlled by the control unit 90 to rotate the shaft 231 around the rotation axis Q1. By this, the spin base 21, the chuck pin 22, and the substrate W rotate integrally around the rotation axis Q1.

Note that the substrate holding unit 2 does not necessarily have the chuck pins 22. For example, the substrate holding unit 2 may hold the substrate W by a chuck method such as vacuum chuck, electrostatic chuck, or Bernoulli chuck.

At least one of the nozzles 3 dispenses liquid toward the first main surface Wa of the substrate W held by the substrate holding unit 2. In the example of FIG. 3, since the first main surface Wa is an upper surface, the nozzle 3 is provided vertically above the substrate W held by the substrate holding unit 2.

In the example of FIG. 3, a nozzle 3c, a nozzle 3w, and a nozzle 3i are provided as the nozzle 3. The nozzle 3c dispenses chemical liquid, the nozzle 3w dispenses rinse liquid, and the nozzle 3i dispenses drying liquid. Specific examples of the chemical liquid, the rinse liquid, and the drying liquid will be described later. Hereinafter, the chemical liquid, the rinse liquid, and the drying liquid are also collectively referred to as process liquid. The nozzle 3 is, for example, a straight nozzle that dispenses the process liquid in a continuous flow state.

In the example of FIG. 3, the nozzle 3 is provided to be movable by a movement drive unit 35. In the example of FIG. 3, a movement drive unit 35c, a movement drive unit 35w, and a movement drive unit 35i are illustrated as the movement drive unit 35. The movement drive unit 35c moves the nozzle 3c, the movement drive unit 35w moves the nozzle 3w, and the movement drive unit 35i moves the nozzle 3i.

The movement drive unit 35c moves the nozzle 3c between a first processing position and a first standby position described below. The first standby position is a position at which the nozzle 3c does not dispense chemical liquid toward the first main surface Wa of the substrate W, and is, for example, a position radially outside the substrate holding unit 2. In the example of FIG. 3, the nozzle 3c stopped at the first standby position is shown. The first processing position is a position at which the nozzle 3c dispenses chemical liquid toward the first main surface Wa of the substrate W, and is, for example, a position facing a central portion of the first main surface Wa of the substrate W in the vertical direction.

The movement drive unit 35w moves the nozzle 3w between a second processing position and a second standby position described below. The second processing position is a position where the nozzle 3w dispenses rinse liquid toward the first main surface Wa of the substrate W, and is, for example, a position facing a central portion of the first main surface Wa of the substrate W in the vertical direction. In the example of FIG. 3, the nozzle 3w stopped at the second processing position is shown. The second standby position is a position at which the nozzle 3w does not dispense rinse liquid toward the first main surface Wa of the substrate W, and is, for example, a position radially outside the substrate holding unit 2.

FIG. 3 illustrates an example of a specific configuration of the movement drive unit 35w. In the example of FIG. 3, the movement drive unit 35w includes an arm 351, a support column 352, and a drive source 353. The support column 352 is provided radially outside a guard 7 to be described later, and extends along the vertical direction. The arm 351 extends along a horizontal direction, and has a tip connected to the nozzle 3w and a base end connected to the support column 352. The drive source 353 is controlled by the control unit 90, and rotates the support column 352 in forward and reverse directions within a predetermined angle range around its central axis Q2. The drive source 353 includes, for example, a motor. When the support column 352 rotates in forward and reverse directions within a predetermined angle range around the central axis Q2, the nozzle 3w reciprocates along a circumferential direction with respect to the central axis Q2. The support column 352 is installed such that the second processing position and the second standby position are located on a movement track of the nozzle 3w. Note that the movement drive unit 35w is not necessarily limited to the mode of FIG. 3, and may include, for example, a linear motion mechanism such as a linear motor. The movement drive unit 35c may have a configuration similar to that of the movement drive unit 35w, for example.

The movement drive unit 35i moves the nozzle 3i between a shutoff processing position and a shutoff standby position to be described below. In the example of FIG. 3, the nozzle 3i is provided integrally with a shutoff plate 6 to be described later, and the movement drive unit 35i integrally moves the nozzle 3i and the shutoff plate 6. The shutoff processing position is a position where the nozzle 3i dispenses drying liquid toward the first main surface Wa of the substrate W, and is, for example, a position facing a central portion of the first main surface Wa of the substrate W in the vertical direction. The shutoff standby position is a position where the nozzle 3i does not dispense drying liquid toward the first main surface Wa of the substrate W, and is, for example, a position vertically above the shutoff processing position. In the example of FIG. 3, the nozzle 3i and the shutoff plate 6 stopped at the shutoff standby position are shown. Since the movement drive unit 35i moves the nozzle 3i along the vertical direction, the movement drive unit 35i can also be referred to as an elevating drive unit. The movement drive unit 35i includes a drive source such as a motor and a power transmission unit that transmits power from the drive source to the nozzle 3i and the shutoff plate 6. The power transmission unit includes, for example, a cam mechanism or a ball screw mechanism.

The nozzle 3 is connected to a downstream end of a supply pipe 31, and an upstream end of the supply pipe 31 is connected to a process liquid supply source. In the example of FIG. 3, a supply pipe 31c, a supply pipe 31w, and a supply pipe 31i are illustrated as the supply pipe 31. A downstream end of the supply pipe 31c is connected to the nozzle 3c, and an upstream end of the supply pipe 31c is connected to a chemical liquid supply source. The chemical liquid supply source includes a tank (not illustrated) that stores chemical liquid, and supplies the chemical liquid to an upstream end of the supply pipe 31c. As the chemical liquid, for example, liquid such as nitric-hydrofluoric acid obtained by mixing hydrofluoric acid, nitric acid, and water, hydrofluoric acid-hydrogen peroxide aqueous solution (FPM) obtained by mixing hydrofluoric acid, hydrogen peroxide, and water, tetramethylammonium hydroxide (TMAH), a mixed solution of sulfuric acid and hydrogen peroxide (SPM), ammonia water, a mixed solution (SC-1) of ammonia, hydrogen peroxide, and water, and a mixed solution (SC-2) of hydrogen chloride, hydrogen peroxide, and water can be applied. Note that the chemical liquid may be single liquid instead of mixed liquid. For example, single liquid of hydrofluoric acid (HF), hydrogen peroxide water, sulfuric acid, and the like can be applied as the chemical liquid.

A downstream end of the supply pipe 31w is connected to the nozzle 3w, and an upstream end of the supply pipe 31w is connected to a rinse liquid supply source. The rinse liquid supply source includes a tank (not illustrated) that stores rinse liquid, and supplies the rinse liquid to an upstream end of the supply pipe 31w. As the rinse liquid, for example, pure water, carbon dioxide water, or ozone water can be applied.

A downstream end of the supply pipe 31i is connected to the nozzle 3i, and an upstream end of the supply pipe 31i is connected to a drying liquid supply source. The drying liquid supply source includes a tank (not illustrated) that stores drying liquid, and supplies the drying liquid to an upstream end of the supply pipe 31i. As the drying liquid, for example, an organic solvent such as isopropyl alcohol can be applied. A surface tension of the drying liquid is lower than a surface tension of other process liquids (for example, both a surface tension of chemical liquid and a surface tension of rinse liquid). Further, volatility of the drying liquid is higher than volatility of other process liquids (for example, both volatility of chemical liquid and volatility of rinse liquid).

A supply valve 32 and a flow rate regulating valve 33 are interposed in the supply pipe 31. In the example of FIG. 3, a supply valve 32c and a flow rate regulating valve 33c are interposed in the supply pipe 31c, a supply valve 32w and a flow rate regulating valve 33w are interposed in the supply pipe 31w, and a supply valve 32i and a flow rate regulating valve 33i are interposed in the supply pipe 31i. The supply valve 32 switches the supply pipe 31 between open and closed states. The flow rate regulating valve 33 adjusts a flow rate of process liquid flowing through the supply pipe 31. The flow rate regulating valve 33 may be a mass flow controller. The supply valve 32 and the flow rate regulating valve 33 are controlled by the control unit 90.

When the supply valve 32 is opened in a state where the substrate holding unit 2 rotates the substrate W and the nozzle 3 is located at the processing position, process liquid is dispensed from the nozzle 3 toward the first main surface Wa of the rotating substrate W. Process liquid attached to the first main surface Wa of the substrate W receives centrifugal force accompanying rotation of the substrate W, flows radially outward along the first main surface Wa, and scatters outward from a peripheral edge of the substrate W. By this, processing corresponding to a type of process liquid is performed on the first main surface Wa of the substrate W. For example, in a case where chemical liquid for cleaning is dispensed, the first main surface Wa of the substrate W is cleaned by the chemical liquid.

The substrate heating unit 40 heats the second main surface Wb of the substrate W held by the substrate holding unit 2. In the example of FIG. 3, the substrate heating unit 40 is provided at a position facing the second main surface Wb of the substrate W in the vertical direction. In the example of FIG. 3, since the second main surface Wb of the substrate W corresponds to a lower surface, the substrate heating unit 40 is provided immediately below the substrate W.

In the example of FIG. 3, the substrate heating unit 40 includes a nozzle 4. The nozzle 4 dispenses a heat medium toward the second main surface Wb of the substrate W. In the example of FIG. 3, since the second main surface Wb of the substrate W corresponds to a lower surface, the nozzle 4 may also be referred to as a lower surface nozzle. In the example of FIG. 3, a through hole is formed in a central portion of the spin base 21 of the substrate holding unit 2, and the shaft 231 is a hollow shaft. The through hole of the spin base 21 and a hollow portion of the shaft 231 are connected in the vertical direction. A part of the nozzle 4 is disposed in the through hole. A dispense port is formed on an upper surface of the nozzle 4, and the dispense port of the nozzle 4 faces a central portion of the second main surface Wb of the substrate W in the vertical direction. The nozzle 4 dispenses a heat medium toward a central portion of the second main surface Wb of the substrate W.

A downstream end of the supply pipe 41 is connected to the nozzle 4. The supply pipe 41 extends inside the shaft 231 and passes through the shaft 231. An upstream end of the supply pipe 41 is connected to a heat medium supply source. The heat medium is fluid (gas or liquid), and is liquid such as water as a more specific example. The heat medium supply source includes, for example, a tank (not illustrated) that stores a heat medium, and supplies the heat medium to an upstream end of the supply pipe 41.

In the example of FIG. 3, the supply pipe 41 is provided with a supply valve 42, a flow rate regulating valve 43, and a heater 44. The supply valve 42 switches the supply pipe 41 between open and closed states. The flow rate regulating valve 43 adjusts a flow rate of a heat medium flowing through the supply pipe 41. The flow rate regulating valve 43 may be a mass flow controller. The heater 44 heats a heat medium flowing through the supply pipe 41. The heater 44 may be, for example, an electric resistance type heater having an electric heating wire. The supply valve 42, the flow rate regulating valve 43, and the heater 44 are controlled by the control unit 90.

When the supply valve 42 is opened, a high-temperature heat medium is dispensed from the nozzle 4 to a central portion of the second main surface Wb of the rotating substrate W. A heat medium attached to a central portion of the second main surface Wb of the substrate W receives centrifugal force accompanying rotation of the substrate W, flows radially outward along the second main surface Wb, and scatters outward from a peripheral edge of the substrate W. When the high-temperature heat medium flows along the second main surface Wb of the substrate W, heat is transferred from the heat medium to the substrate W, and the substrate W is heated.

In the example of FIG. 3, the processing unit 1 is provided with the guard 7 and a guard elevating drive unit 71. The guard 7 has a tubular shape with the rotation axis Q1 as a central axis, and surrounds the substrate holding unit 2. The guard 7 can receive process liquid and a heat medium scattered from a peripheral edge of the substrate W. The guard 7 is elevated by the guard elevating drive unit 71 between an upper position and a lower position described below. The upper position is a position where an upper end of the guard 7 is vertically above the substrate W held by the substrate holding unit 2. The guard 7 can receive process liquid and a heat medium scattered from a peripheral edge of the substrate W in a state of being located at the upper position. The lower position is a position lower than the upper position, and is, for example, a position where an upper end of the guard 7 is vertically lower than an upper surface of the spin base 21.

In the example of FIG. 3, a plurality of the guards 7 are provided. A plurality of the guards 7 are arranged concentrically. A plurality of the guards 7 may be selectively used according to a type of process liquid. In the example of FIG. 3, a cup 72 corresponding to each of the guards 7 is provided. The cup 72 has an annular (for example, ring-shaped) recessed portion (groove) surrounding the rotation axis Q1. Each of the cups 72 receives process liquid flowing down on an inner peripheral surface of the corresponding guard 7. An upstream end of a discharge pipe 12 is connected to, for example, a bottom portion of each of the cups 72. Process liquid received by each of the cups 72 is discharged to the outside of the processing unit 1 through the discharge pipe 12.

In the example of FIG. 3, the processing unit 1 further includes the shutoff plate 6. The shutoff plate 6 is provided at a position facing the first main surface Wa of the substrate W held by the substrate holding unit 2 in the vertical direction. In the example of FIG. 3, since the first main surface Wa of the substrate W corresponds to an upper surface, the shutoff plate 6 is provided vertically above the substrate W. The shutoff plate 6 has, for example, a plate shape, and is provided in a posture in which a thickness direction of the shutoff plate 6 is along the vertical direction. A lower surface of the shutoff plate 6 is a facing surface facing the first main surface Wa of the substrate W. The shutoff plate 6 has, for example, a circular shape in plan view. A diameter (that is, a diameter of a facing surface) of the shutoff plate 6 may be, for example, 80% or more, 90% or more, or equal to or more than a diameter of the substrate W. A through hole penetrating the shutoff plate 6 in the vertical direction is formed in a central portion of the shutoff plate 6, and the nozzle 3i is provided inside the through hole.

In the example of FIG. 3, a hollow shaft 61 is provided on an upper surface of the shutoff plate 6. The hollow shaft 61 has a hollow portion, and the hollow portion is connected to the through hole of the shutoff plate 6 in the vertical direction. A diameter of an outer peripheral surface of the nozzle 3i is smaller than a diameter of an inner peripheral surface of the shutoff plate 6 and the hollow shaft 61. A space between an outer peripheral surface of the nozzle 3i and an inner peripheral surface of the shutoff plate 6 and the hollow shaft 61 functions as a gas flow path 3g as described later.

In the example of FIG. 3, an upper portion of the hollow shaft 61 is connected to a downstream end of a supply pipe 31g. That is, a downstream end of the supply pipe 31g is connected to the gas flow path 3g between an outer peripheral surface of the nozzle 3i and an inner peripheral surface of the shutoff plate 6 and the hollow shaft 61. An upstream end of the supply pipe 31g is connected to a gas supply source. The gas supply source includes a storage portion (not illustrated) that stores inert gas, and supplies the inert gas to an upstream end of the supply pipe 31g. The inert gas contains, for example, at least one of nitrogen gas and rare gas. The rare gas includes, for example, argon gas.

The supply pipe 31g is provided with a supply valve 32g, a flow rate regulating valve 33g, and a heater 34g. The supply valve 32g switches the supply pipe 31g between open and closed states. The flow rate regulating valve 33g adjusts a flow rate of inert gas flowing through the supply pipe 31g. The heater 34g heats inert gas flowing through the supply pipe 31g. The heater 34g may be, for example, an electric resistance type heater having an electric heating wire. The supply valve 32g, the flow rate regulating valve 33g, and the heater 34g are controlled by the control unit 90.

When the supply valve 32g is opened and the heater 34g is operated, high-temperature inert gas is dispensed from a central portion of a lower surface of the shutoff plate 6 (that is, a lower end port of the gas flow path 3g) toward a central portion of the first main surface Wa of the substrate W. By this, drying of the substrate W can be promoted.

### <Operation example of substrate processing apparatus>

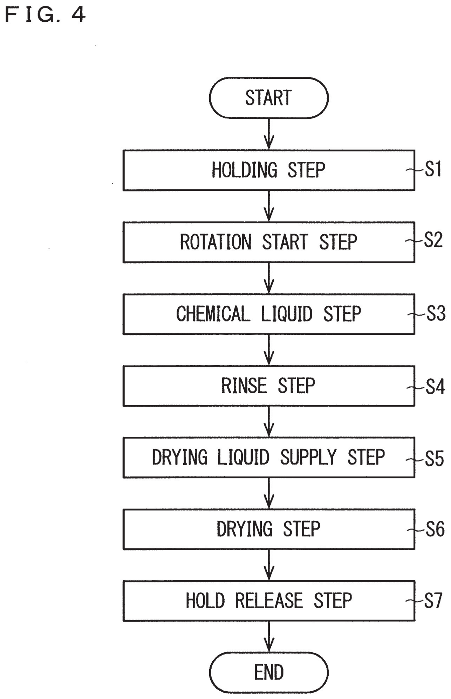

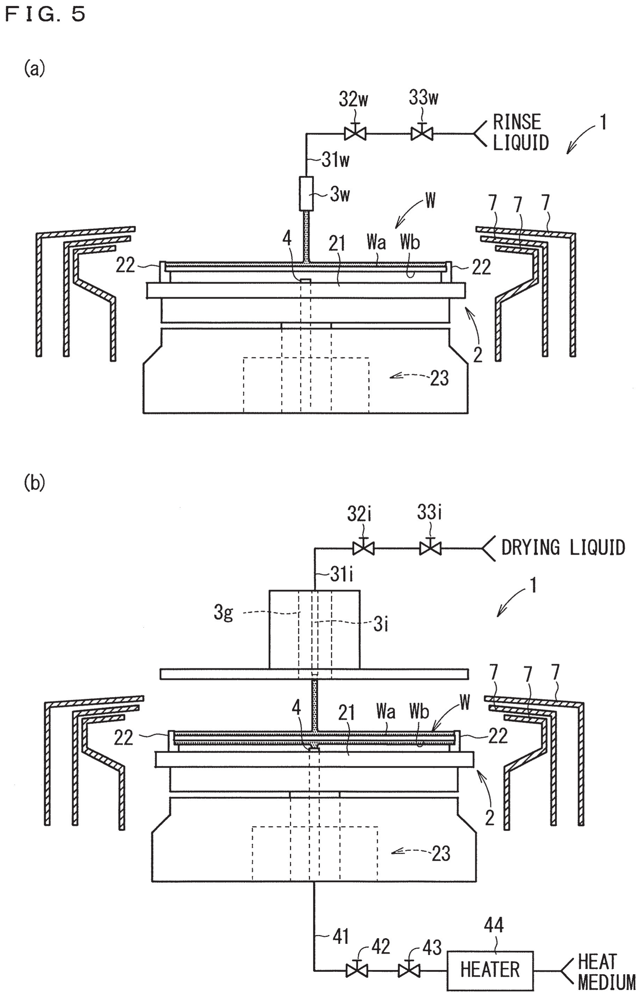

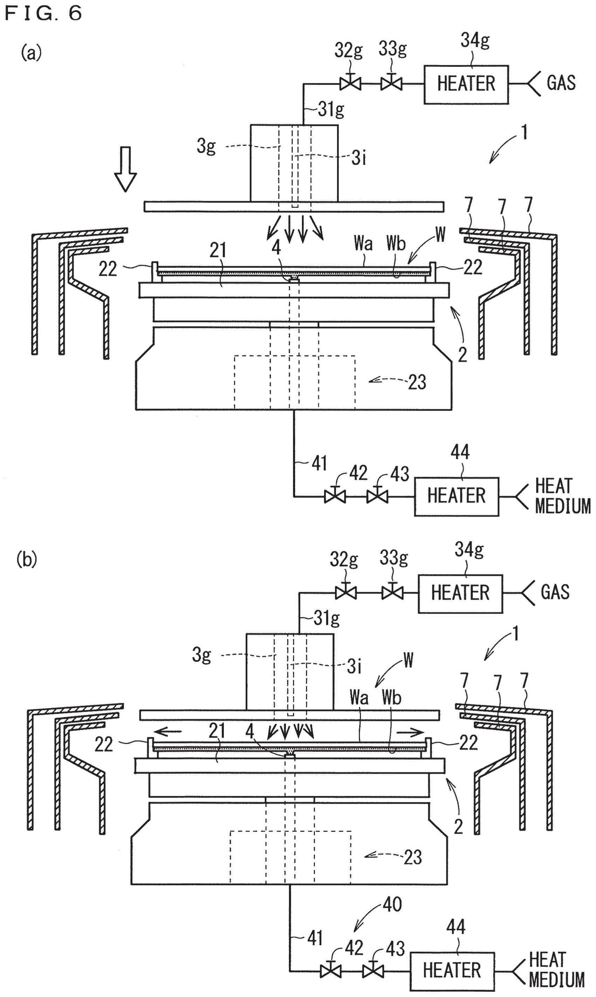

Next, an example of an operation of the processing unit 1 will be described. FIG. 4 is a flowchart illustrating an example of an operation of the processing unit 1. The control unit 90 causes the processing unit 1 to execute processing of Steps S1 to S7 according to a preset processing procedure (recipe). FIGS. 5 and 6 are diagrams schematically illustrating an example of a state of the processing unit 1 in each step.

First, the second transfer unit 122 transfers the substrate W to the processing unit 1. Then, the substrate holding unit 2 holds the substrate W received from the second transfer unit 122 (Step S1: holding step). As a specific example, the substrate holding unit 2 displaces a plurality of the chuck pins 22 from the release positions to the holding positions. By this, a plurality of the chuck pins 22 hold the substrate W. The substrate holding unit 2 continues to hold the substrate W until processing on the substrate W is completed.

Next, the substrate holding unit 2 starts rotation of the substrate W (Step S2: rotation start step). The substrate holding unit 2 may continue rotation of the substrate W until processing of the substrate W is completed.

Next, the processing unit 1 supplies chemical liquid to the first main surface Wa of the substrate W (Step S3: chemical liquid step). First, the movement drive unit 35c moves the nozzle 3c to the first processing position. Further, the guard elevating drive unit 71 raises the chemical liquid guard 7 to the upper position. Then, the control unit 90 opens the supply valve 32c. That is, the control unit 90 switches the supply valve 32c from a closed state to an open state. By this, chemical liquid is dispensed from the nozzle 3c toward the first main surface Wa of the rotating substrate W. Chemical liquid attached to the first main surface Wa of the substrate W flows radially outward by receiving centrifugal force accompanying rotation of the substrate W and scatters from a peripheral edge of the substrate W. At this time, chemical liquid acts on the first main surface Wa of the substrate W, so that chemical liquid processing corresponding to a type of the chemical liquid is performed on the first main surface Wa of the substrate W. For example, the processing unit 1 performs cleaning processing of cleaning and removing impurities on the first main surface Wa of the substrate W or etching processing of etching a predetermined film of the first main surface Wa of the substrate W. Chemical liquid scattered from a peripheral edge of the substrate W is received by the guard 7 and discharged to the outside of the chamber 10 through the discharge pipe 12.

When the substrate W is sufficiently processed, the control unit 90 closes the supply valve 32c. As a specific example, the control unit 90 measures elapsed time from start of dispense of chemical liquid, and determines whether or not the elapsed time is predetermined chemical liquid time or more. The chemical liquid time is preset to time during which chemical liquid processing is sufficiently performed. The elapsed time is measured by, for example, a timer circuit (not illustrated) belonging to the control unit 90. The control unit 90 switches the supply valve 32c from an open state to a closed state when the elapsed time is equal to or more than the chemical liquid time. Further, after the supply valve 32c is closed, the movement drive unit 35c moves the nozzle 3c to the first standby position.

Next, the processing unit 1 supplies rinse liquid to the first main surface Wa of the substrate W (Step S4: rinse step). Specifically, first, the movement drive unit 35w moves the nozzle 3w to the second processing position. Further, in a case where the guard 7 for rinse liquid is different from the guard 7 for chemical liquid, the guard elevating drive unit 71 appropriately lifts and lowers the guard 7 to position the guard 7 for rinse liquid at the upper position. Then, the control unit 90 opens the supply valve 32w. That is, the control unit 90 switches the supply valve 32w from a closed state to an open state. By this, as illustrated in FIG. 5(a), rinse liquid is dispensed from the nozzle 3w toward the first main surface Wa of the rotating substrate W. Rinse liquid attached to the first main surface Wa of the substrate W flows radially outward by receiving centrifugal force accompanying rotation of the substrate W and scatters from a peripheral edge of the substrate W. At this time, the rinse liquid pushes chemical liquid on the first main surface Wa of the substrate W radially outward. By this, process liquid on the first main surface Wa of the substrate W is switched from chemical liquid to rinse liquid. Process liquid scattered from a peripheral edge of the substrate W is received by the guard 7 and discharged to the outside of the chamber 10 through the discharge pipe 12.

When chemical liquid is sufficiently replaced with rinse liquid, the control unit 90 closes the supply valve 32w. As a specific example, the control unit 90 measures elapsed time from start of dispense of rinse liquid, and switches the supply valve 32w from an open state to a closed state when the elapsed time becomes equal to or more than predetermined rinse time. The rinse time is preset to time during which chemical liquid is sufficiently replaced with rinse liquid. Further, after the supply valve 32w is closed, the movement drive unit 35w moves the nozzle 3w to the second standby position.

Next, the processing unit 1 supplies drying liquid to the first main surface Wa of the substrate W (Step S5: drying liquid supply step). Specifically, first, the movement drive unit 35i integrally moves the nozzle 3i and the shutoff plate 6 to the shutoff processing position. Further, in a case where the guard 7 for drying liquid is different from the guard 7 for rinse liquid, the guard elevating drive unit 71 appropriately lifts and lowers the guard 7 to raise the guard 7 for drying liquid to the upper position. Then, the control unit 90 opens the supply valve 32i. That is, the control unit 90 switches the supply valve 32i from a closed state to an open state.

When the supply valve 32i is opened, as illustrated in FIG. 5(b), drying liquid is dispensed from the nozzle 3i toward the first main surface Wa of the rotating substrate W. Temperature of drying liquid may be, for example, room temperature (for example, about 25 degrees Celsius). Drying liquid attached to the first main surface Wa of the substrate W flows radially outward by receiving centrifugal force accompanying rotation of the substrate W and scatters from a peripheral edge of the substrate W. At this time, the drying liquid pushes away rinse liquid on the first main surface Wa of the substrate W, so that process liquid on the first main surface Wa of the substrate W is switched from the rinse liquid to the drying liquid. Process liquid scattered from a peripheral edge of the substrate W is received by the guard 7 and discharged to the outside of the chamber 10 through the discharge pipe 12. A rotation speed of the substrate W in the drying liquid supply step may be set to, for example, 150 rpm or more and 600 rpm or less, or may be set to 200 rpm or more and 400 rpm or less. As a more specific example, the rotational speed may be set to 300 rpm.

Further, the processing unit 1 may heat the substrate W when drying liquid is supplied. That is, the substrate heating unit 40 may heat the second main surface Wb of the substrate W. As a more specific example, the control unit 90 may open the supply valve 42 and operate the heater 44. According to this, as illustrated in FIG. 5(b), a high-temperature heat medium (for example, hot water) is dispensed from the nozzle 4 toward the second main surface Wb of the rotating substrate W. The heater 44 may heat a heat medium to, for example, 60°C or more, 70°C or more, or 80°C or more. Further, the heater 44 may adjust a temperature of the heat medium to, for example, lower than a boiling point of drying liquid. The temperature of the heat medium here is, for example, a temperature of a heat medium at a dispense port of the nozzle 4. The flow rate regulating valve 43 may adjust a flow rate of a heat medium to a value larger than a flow rate of drying liquid, for example. More specifically, the flow rate regulating valve 43 may adjust a flow rate of a heat medium to 1000 mL (milliliters)/min or more, or 1500 mL/min or more.

A heat medium attached to a central portion of the second main surface Wb of the substrate W flows radially outward by receiving centrifugal force accompanying rotation of the substrate W and scatters from a peripheral edge of the substrate W. When the high-temperature heat medium flows along the second main surface Wb of the substrate W, heat is transferred from the heat medium to the substrate W, and the substrate W is heated. The heat of the substrate W is transferred to drying liquid on the first main surface Wa. For this reason, drying liquid on the first main surface Wa of the substrate W is also heated and the temperature rises.

When the rinse liquid is sufficiently replaced with the drying liquid, the processing unit 1 dries the substrate W (Step S6: drying step). Specifically, the processing unit 1 measures elapsed time from start of dispense of drying liquid, and determines whether the elapsed time is equal to or more than predetermined drying liquid supply time. The drying liquid supply time is preset to such time during which rinse liquid is sufficiently replaced with drying liquid. The drying liquid supply time is set to, for example, about several tens of seconds, specifically about 40 seconds. Then, when the elapsed time is equal to or more than the drying liquid supply time, the processing unit 1 dries the substrate W. Specifically, the control unit 90 closes the supply valve 32i, opens the supply valve 32g, operates the heater 34g, causes the movement drive unit 35i to lower the shutoff plate 6 to a drying position closer to the substrate W than the shutoff processing position, and causes the substrate holding unit 2 to increase a rotation speed of the substrate W.

When the supply valve 32g is opened, as illustrated in FIG. 6(a), high-temperature inert gas is dispensed from a gas dispense port (that is, a lower end port of the gas flow path 3g) at a central portion of a lower surface of the shutoff plate 6 toward the first main surface Wa of the substrate W. In FIG. 6, a direction in which inert gas flows is schematically indicated by an arrow immediately below the shutoff plate 6. The heater 34g may heat inert gas to, for example, 60°C or more, 70°C or more, or 80°C or more. Temperature of inert gas may be, for example, temperature of the inert gas at a gas dispense port of the gas flow path 3g. The flow rate regulating valve 33g may adjust a flow rate of inert gas to, for example, 10 L (liters)/min or more and 300 L/min or less.

In FIG. 6(a), lowering of the shutoff plate 6 is schematically indicated by a block arrow added to the side of the shutoff plate 6. Here, the movement drive unit 35i integrally lowers the nozzle 3i and the shutoff plate 6 in a state where inert gas is dispensed from the gas flow path 3g. When the shutoff plate 6 is lowered to the drying position, as illustrated in FIG. 6(b), an interval between the shutoff plate 6 and the first main surface Wa of the substrate W can be narrowed. That is, an interval between the shutoff plate 6 and the substrate W in the drying step can be made narrower than an interval between the shutoff plate 6 and the substrate W in the drying liquid supply step. For this reason, in the drying step, a flow rate of inert gas flowing out radially outward from a peripheral edge of the shutoff plate 6 and the substrate W can be increased. An interval between a lower surface of the shutoff plate 6 and the first main surface Wa of the substrate W in the drying step is set to, for example, about several millimeters (for example, 5 mm) or less.

The substrate holding unit 2 may increase a rotation speed of the substrate W in a monotonically non-decreasing manner without reducing the rotation speed of the substrate W at the time of transition from the drying liquid supply step to the drying step and at an initial stage of the drying step. The substrate holding unit 2 may rotate the substrate W at a rotation speed of, for example, 800 rpm or more and 2500 rpm or less, or may rotate the substrate W at a rotation speed of 800 rpm or more and 1500 rpm or less. Further, the substrate holding unit 2 may increase a rotation speed of the substrate W gradually (for example, stepwise) during or after lowering of the shutoff plate 6.

By improving the rotation speed, an amount of drying liquid scattered from a peripheral edge of the substrate W can be increased. For this reason, drying liquid can be evaporated in a state where a liquid film of the drying liquid on the first main surface Wa is thinned. Therefore, the drying liquid can be evaporated in shorter time.

On the other hand, when a rotation speed of the substrate W increases, a heat medium is likely to wrap around a peripheral edge portion of the first main surface Wa from the second main surface Wb of the substrate W via a peripheral edge. However, in the above example, inert gas flows out radially outward from between the shutoff plate 6 and the substrate W at a high flow rate. For this reason, inert gas can push back a heat medium radially outward. Therefore, wraparound of the heat medium can be suppressed or prevented. In other words, an interval between the shutoff plate 6 and the substrate W and a flow rate of inert gas may be set to the extent that wraparound of a heat medium can be sufficiently suppressed.

When drying liquid is sufficiently evaporated, the substrate heating unit 40 stops heating the substrate W. As a specific example, the control unit 90 measures elapsed time from stop of dispense of drying liquid, and determines whether or not the measured time is equal to or more than predetermined evaporation time. The evaporation time is preset to such time during which the first main surface Wa of the substrate W is sufficiently dried. When the elapsed time is equal to or more than the evaporation time, the control unit 90 switches the supply valve 42 from an open state to a closed state. By this, supply of a heat medium to the second main surface Wb of the substrate W is stopped. That is, heating of the substrate W by the substrate heating unit 40 is stopped.

Then, the control unit 90 stops rotation of the substrate W, for example, when predetermined drying time sufficient for drying the second main surface Wb of the substrate W elapses. Further, the movement drive unit 35i integrally raises the nozzle 3i and the shutoff plate 6 to the shutoff standby position, and the guard elevating drive unit 71 lowers the guard 7 to the lower position.

Next, the substrate holding unit 2 releases the holding of the substrate W (Step S7: hold release step). Then, the second transfer unit 122 takes out the processed substrate W from the processing unit 1.

As described above, the processing unit 1 can perform processing on the substrate W. Moreover, in the present embodiment, the substrate heating unit 40 heats the second main surface Wb of the substrate W after supply of drying liquid is stopped (the drying step, FIG. 6). For this reason, in the drying step, drying liquid on the first main surface Wa of the substrate W can be evaporated at a higher temperature.

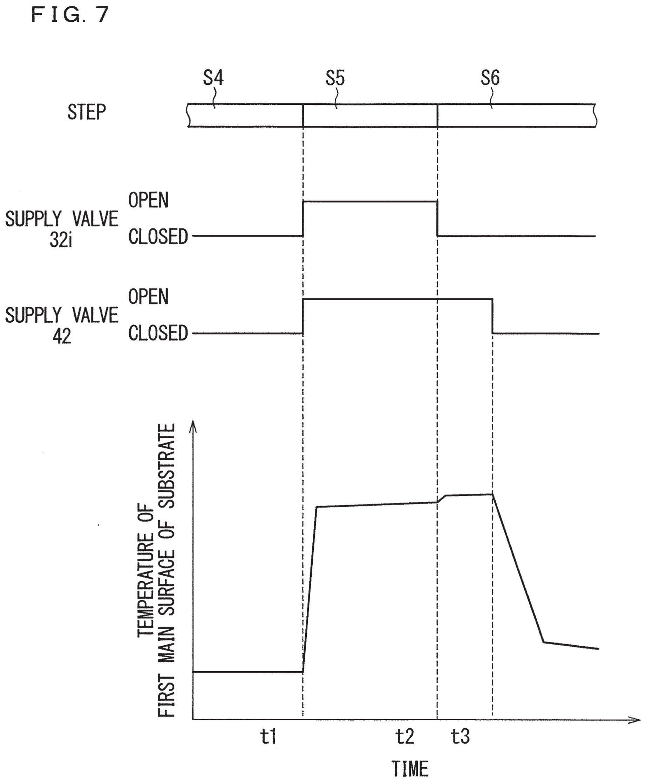

FIG. 7 is a diagram schematically illustrating an example of a timing chart of the processing unit 1 and a temporal change in temperature of the first main surface Wa of the substrate W (hereinafter, referred to as substrate temperature). In the example of FIG. 7, at a time point t1, the control unit 90 switches the supply valve 32i and the supply valve 42 from a closed state to an open state. For this reason, at the time point t1, the nozzle 3i starts to dispense drying liquid, and the nozzle 4 starts to dispense a high-temperature heat medium. From this dispense of the drying liquid the substantial drying liquid supply step (Step S5) starts. Further, by dispense of the heat medium, substrate temperature of the first main surface Wa of the substrate W rises with lapse of time. The substrate temperature may rise at a high rate of rise to some extent, and then rise slowly or converge.

In the example of FIG. 7, at a time point t2 after the time point t1, the control unit 90 switches the supply valve 32i from an open state to a closed state. For this reason, at the time point t2, dispense of the drying liquid is stopped. As the dispense of the drying liquid stops, the drying liquid supply step is substantially completed.

On the other hand, in the example of FIG. 7, the supply valve 42 remains open even at and after the time point t2. For this reason, in the evaporation time at and after the time point t2 (time from the time point t2 to the time point t3 in FIG. 7: corresponding to a predetermined period), the nozzle 4 dispenses a heat medium, and the substrate W continues to receive an amount of heat from the heat medium. Therefore, the substrate temperature of the first main surface Wa of the substrate W during the evaporation time can be made equal to or more than the substrate temperature when drying liquid is supplied. In the example of FIG. 7, temperature of the first main surface Wa of the substrate W rises at and after the time point t2. This is because no new drying liquid is supplied to the first main surface Wa of the substrate W at and after the time point t2. That is, when drying liquid at temperature lower than that of a heat medium is supplied to the first main surface Wa, the drying liquid cools the substrate W, while temperature of the substrate W rises since supply of drying liquid is finished at and after the time point t2. For this reason, the substrate temperature of the first main surface Wa of the substrate W during the evaporation time is higher than the substrate temperature of the first main surface Wa of the substrate W in the drying liquid supply step.

Since temperature of the first main surface Wa of the substrate W can be considered to be substantially equal to temperature of drying liquid on the first main surface Wa, temperature of drying liquid during the evaporation time is also higher than temperature of drying liquid in the drying liquid supply step. Further, a surface tension of drying liquid decreases as temperature of the drying liquid increases. Since temperature of drying liquid during the evaporation time is high as described above, a surface tension of the drying liquid during the evaporation time can be reduced. Furthermore, an evaporation rate of the drying liquid can also be increased.

Collapse of a pattern is more likely to occur as a surface tension of drying liquid is higher. Further, collapse of a pattern is more likely to occur as an evaporation rate is lower. This is because the lower the evaporation rate, the larger the impulse of surface tension acting on a pattern. According to the present embodiment, since an evaporation rate can be increased while a surface tension of drying liquid is reduced, a collapse ratio of a pattern can be effectively reduced.

In the example of FIG. 7, at a time point t3 after the time point t2, the control unit 90 switches the supply valve 42 from an open state to a closed state. For this reason, at the time point t3, the nozzle 4 stops dispense of a heat medium. That is, the substrate heating unit 40 stops heating of the second main surface Wb of the substrate W at the time point t3. Therefore, at and after the time point t3, temperature of the first main surface Wa of the substrate W decreases with lapse of time.

Further, in the above example, in the drying step (Step S6), high-temperature inert gas is supplied to the first main surface Wa of the substrate W. For this reason, temperature of drying liquid on the first main surface Wa of the substrate W in drying liquid can be further increased, and evaporation can be further promoted. Therefore, a collapse ratio of a pattern can be further reduced. Further, temperature distribution of drying liquid on the first main surface Wa of the substrate W can also be made uniform.

In the above example, in the drying step, the substrate holding unit 2 increases a rotation speed of the substrate W. For this reason, it is possible to further promote evaporation of drying liquid while increasing an amount of the drying liquid scattered outward from a peripheral edge of the substrate W. That is, a liquid film of the drying liquid on the first main surface Wa is thinned by scattering, and evaporation of the drying liquid is promoted. By this, a collapse ratio of a pattern can be further reduced.

Further, in the above example, in the drying step, the movement drive unit 35i moves the shutoff plate 6 to the drying position closer to the first main surface Wa than the shutoff processing position. For this reason, an interval between the shutoff plate 6 and the substrate W can be further narrowed, and a flow rate of inert gas flowing out radially outward from between the shutoff plate 6 and the substrate W can be increased. For this reason, it is possible to suppress or prevent wraparound of a heat medium at a peripheral edge of the substrate W. According to this, a collapse ratio of a pattern of a peripheral edge portion of the first main surface Wa of the substrate W can be reduced, and adhesion of particles to the peripheral edge portion can be suppressed.

Conversely, in the drying liquid supply step, the shutoff plate 6 is stopped at the shutoff processing position farther from the substrate W than the drying position. For this reason, even if drying liquid dispensed from the nozzle 3i bounces off the first main surface Wa of the substrate W, the possibility that the bounced drying liquid adheres to a lower surface of the shutoff plate 6 can be reduced. When drying liquid adheres to a lower surface of the shutoff plate 6, for example, a droplet of the adhered drying liquid may fall on the first main surface Wa of the substrate W during processing of the next substrate W. This is not preferable because it may lead to a processing failure. When the shutoff plate 6 is stopped at the shutoff processing position in the drying liquid supply step as described above, the occurrence of such a failure can be suppressed.

Further, in the above example, in the drying liquid supply step, the substrate heating unit 40 heats the second main surface Wb of the substrate W, and also heats the second main surface Wb of the substrate W at the time of transition from the drying liquid supply step to the drying step. That is, the substrate heating unit 40 continues to heat the second main surface Wb of the substrate W over the drying liquid supply step and an initial stage of the drying step. According to this, temperature of the first main surface Wa of the substrate W can be maintained higher at a start time point (that is, the time point t2) of the drying step. That is, temperature of drying liquid can be increased from the start time point of the drying step. Therefore, in the drying step, an evaporation rate of drying liquid can be more quickly increased, and a collapse ratio of a pattern can be more appropriately reduced.

Further, in the drying liquid supply step, by increasing temperature of drying liquid on the first main surface Wa of the substrate W, efficiency of replacing rinse liquid with drying liquid can be improved. That is, it is possible to prevent rinse liquid having a larger surface tension than drying liquid from remaining. For this reason, a collapse ratio of a pattern in the drying step can be further reduced.

### <Second embodiment>

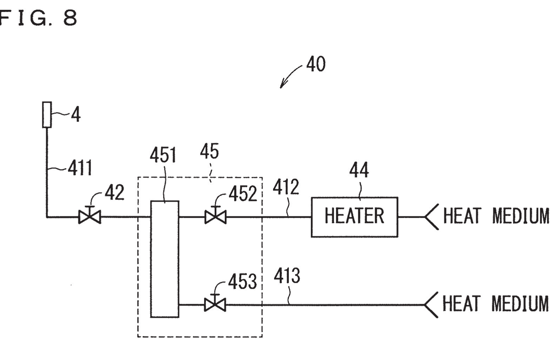

A configuration of the processing unit 1 according to a second embodiment is similar to that of the first embodiment except for a specific configuration of the substrate heating unit 40. FIG. 8 is a diagram schematically illustrating an example of a configuration of the substrate heating unit 40 according to the second embodiment. In the example of FIG. 8, the substrate heating unit 40 includes the nozzle 4, a common pipe 411, a first temperature pipe 412, a second temperature pipe 413, and a mixing unit 45. A downstream end of the common pipe 411 is connected to the nozzle 4, and an upstream end of the common pipe 411 is connected to the mixing unit 45. A downstream end of the first temperature pipe 412 and a downstream end of the second temperature pipe 413 are also connected to the mixing unit 45. Upstream ends of the first temperature pipe 412 and the second temperature pipe 413 are connected to a heat medium supply source. A heat medium at a first medium temperature flows through the first temperature pipe 412, and a heat medium at a second medium temperature flows through the second temperature pipe 413. The second medium temperature is lower than the first medium temperature. Hereinafter, a heat medium at the first medium temperature flowing through the first temperature pipe 412 is also referred to as a high-temperature heat medium, and a heat medium at the second medium temperature flowing through the second temperature pipe 413 is also referred to as a low-temperature heat medium. In the example of FIG. 8, the first temperature pipe 412 is provided with the heater 44. The heater 44 heats the high-temperature heat medium flowing through the first temperature pipe 412 so that temperature of a heat medium becomes the first medium temperature. The second medium temperature may be room temperature. Alternatively, a heater (not illustrated) may be provided in the second temperature pipe 413 to heat a low-temperature heat medium to the second medium temperature higher than room temperature.

The mixing unit 45 mixes a high-temperature heat medium from the first temperature pipe 412 and a low-temperature heat medium from the second temperature pipe 413 at a variable mixing ratio, and causes the mixed heat medium to flow into the common tube 411. A mixing ratio of the mixing unit 45 is controlled by the control unit 90. In the example of FIG. 8, the mixing unit 45 includes a multiple valve 451, a flow rate regulating valve 452, and a flow rate regulating valve 453. The flow rate regulating valve 452 adjusts a flow rate of a high-temperature heat medium flowing through the first temperature pipe 412. The flow rate regulating valve 453 adjusts a flow rate of a low-temperature heat medium flowing through the second temperature pipe 413. The flow rate regulating valve 452 and the flow rate regulating valve 453 are controlled by the control unit 90. The control unit 90 can adjust a mixing ratio by adjusting each flow rate. The multiple valve 451 switches connection and disconnection between the common pipe 411 and the first temperature pipe 412, and switches connection and disconnection between the common pipe 411 and the second temperature pipe 413. Note that in a case where the multiple valve 451 itself has a function of adjusting a flow rate, the flow rate regulating valve 452 and the flow rate regulating valve 453 are unnecessary.

In the example of FIG. 8, the common pipe 411 is provided with the supply valve 42. The supply valve 42 switches the common pipe 411 between open and closed states. The supply valve 42 is controlled by the control unit 90.

### <Operation example of substrate processing apparatus>

An operation of the processing unit 1 according to the second embodiment is as illustrated in FIG. 4 referred to in the first embodiment. However, a specific operation of the substrate heating unit 40 is different from that of the first embodiment. In the second embodiment, in the drying step (Step S6), the substrate heating unit 40 heats the substrate W with a second amount of heat per unit time larger than a first amount of heat per unit time in the drying liquid supply step (Step S5). As a more specific example, the substrate heating unit 40 supplies a heat medium having temperature higher than temperature of a heat medium supplied to the substrate W in the drying liquid supply step to the substrate W in the drying step. Specifically, the substrate heating unit 40 adjusts a mixing ratio of a high-temperature heat medium and a low-temperature heat medium, and supplies a heat medium having higher temperature than a heat medium in the drying liquid supply step to the second main surface of the substrate W in the drying step.

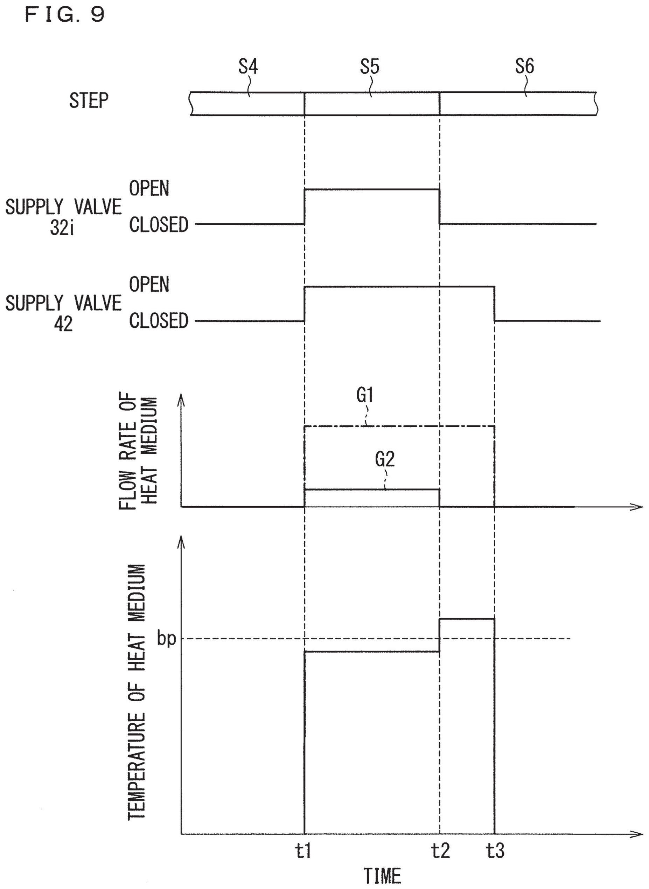

FIG. 9 is a diagram schematically illustrating an example of a timing chart of the processing unit 1 according to the second embodiment, a flow rate of a heat medium, and a temporal change of temperature of the heat medium. In the example of FIG. 9, an example of a flow rate of a high-temperature heat medium is indicated by a graph G1, and an example of a flow rate of a low-temperature heat medium is indicated by a graph G2.

In the example of FIG. 9, a flow rate of a high-temperature heat medium is constant in a period from the time point t1 to the time point t3. On the other hand, a flow rate of a low-temperature heat medium decreases at the time point t2. That is, a flow rate of a low-temperature heat medium in the evaporation time from the time point t2 to the time point t3 is smaller than a flow rate of a low-temperature heat medium in the drying liquid supply step from the time point t1 to the time point t2. Therefore, temperature of a heat medium dispensed from the nozzle 4 during the evaporation time is higher than temperature of a heat medium dispensed from the nozzle 4 in the drying liquid supply step.

Note that, in the second embodiment, since temperature of a heat medium dispensed from the nozzle 4 only needs to be higher in the drying step (Step S6) than in the drying liquid supply step (Step S5), flow rates of a high-temperature heat medium and a low-temperature heat medium are not limited to the above. In short, a ratio of a flow rate of a high-temperature heat medium to a flow rate of a low-temperature heat medium (= a flow rate of a high-temperature heat medium/a flow rate of a low-temperature heat medium) only needs to be higher in the drying step than in the drying liquid supply step.

Temperature of a heat medium dispensed from the nozzle 4 in the drying liquid supply step may be adjusted to be lower than a boiling point bp of drying liquid. In a case where drying liquid is isopropyl alcohol, the boiling point bp of the drying liquid is about 82.4°C. In this case, temperature of a heat medium in the drying liquid supply step may be adjusted to a temperature less than 82.4°C. As a specific example, the first medium temperature of a high-temperature heat medium is set to a value larger than the boiling point bp of drying liquid (for example, 85°C), and the second medium temperature of a low-temperature heat medium is set to a value smaller than a boiling point pb of drying liquid (for example, room temperature). Then, the mixing unit 45 mixes the high-temperature heat medium and the low-temperature heat medium at a mixing ratio at which temperature of the heat medium is lower than the boiling point bp of the drying liquid.

According to this, since temperature of a heat medium dispensed from the nozzle 4 is less than the boiling point bp of the drying liquid, drying liquid on the first main surface Wa of the substrate W is also less than the boiling point bp. Therefore, boiling of the drying liquid on the first main surface Wa of the substrate W during supply of the drying liquid can be more reliably suppressed. If drying liquid on the first main surface Wa of the substrate W boils during supply of drying liquid, many particles adhere to the first main surface Wa of the substrate W. In the present embodiment, such adhesion of particles can be more reliably suppressed.

On the other hand, in the drying step, dispense of drying liquid from the nozzle 3i is stopped. For this reason, even when drying liquid on the first main surface Wa of the substrate W boils, this hardly causes adhesion of particles. In view of the above, the substrate heating unit 40 may adjust temperature of a heat medium in the evaporation time from the time point t2 to the time point t3 to the boiling point bp of drying liquid or more. That is, the mixing unit 45 may employ a mixing ratio at which temperature of a heat medium is equal to or more than the boiling point bp of drying liquid. In the example of FIG. 9, a flow rate of a low-temperature heat medium is set to zero.

Note that the mixing unit 45 may gradually change a mixing ratio with lapse of time. For example, the mixing unit 45 may gradually change a mixing ratio during lowering time in which the shutoff plate 6 is lowered from the shutoff processing position to the drying position.

As described above, in the second embodiment, temperature of a heat medium in the drying step is higher than temperature of a heat medium in the drying liquid supply step. For this reason, temperature of the substrate W and drying liquid in the drying step can be further increased. Therefore, an evaporation rate of drying liquid can be further improved in the drying step. For this reason, a collapse ratio of a pattern of the substrate W can be further reduced.

Conversely, temperature of the substrate W and drying liquid in the drying liquid supply step can be made lower than that in the drying step. For this reason, boiling of drying liquid on the first main surface Wa of the substrate W in the drying liquid supply step can be suppressed or prevented, and adhesion of particles to the first main surface Wa can be suppressed.

In the above example, the substrate heating unit 40 changes a mixing ratio of the mixing unit 45 to change temperature of a heat medium dispensed from the nozzle 4. According to this, temperature of a heat medium can be rapidly changed. For this reason, in an initial stage of the drying step, temperature of a heat medium can be increased more quickly, and an evaporation rate of drying liquid can be increased more quickly. This also makes it possible to further reduce a collapse ratio of a pattern.

### <Third embodiment>

In the first embodiment and the second embodiment, the substrate heating unit 40 starts heating the second main surface Wb of the substrate W substantially simultaneously with start of dispense of drying liquid from the nozzle 3i in the drying liquid supply step (Step S5) (see FIGS. 7 and 9). However, the present invention is not necessarily limited to this. The substrate heating unit 40 may start heating the second main surface Wb of the substrate W at a time point after start of dispense of drying liquid from the nozzle 3i.

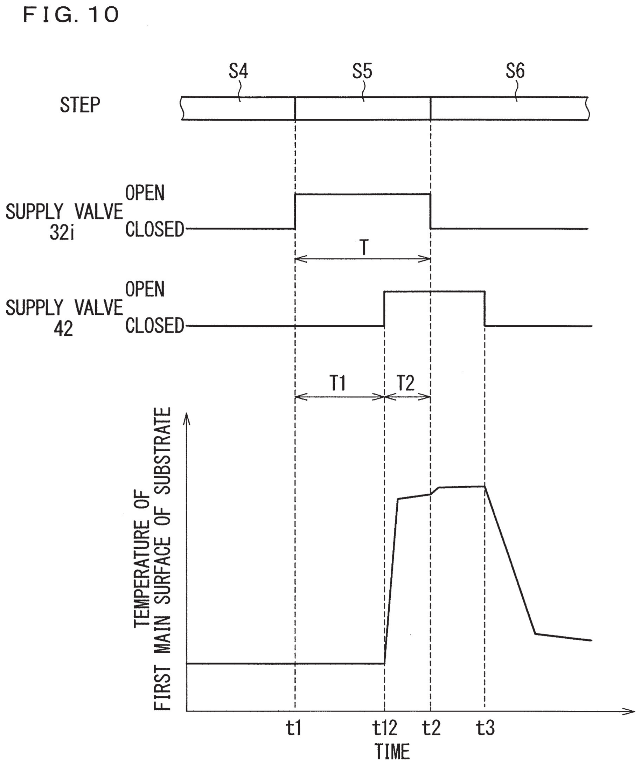

FIG. 10 is a diagram schematically illustrating an example of a timing chart of the processing unit 1 according to a third embodiment and a temperature change of the first main surface Wa of the substrate W. In the example of FIG. 10, the control unit 90 switches the supply valve 32i from a closed state to an open state at the time point t1. By this, drying liquid starts to be dispensed from the nozzle 3i toward the first main surface Wa of the substrate W. That is, at the time point t1, the substantial drying liquid supply step starts. On the other hand, in the example of FIG. 10, the control unit 90 switches the supply valve 42 from a closed state to an open state at a time point t12 after the time point t1. By this, a high-temperature heat medium starts to be dispensed from the nozzle 4 toward the second main surface Wb of the substrate W. That is, the substrate heating unit 40 starts heating the second main surface Wb of the substrate W. Then, at the time point t2 after the time point t12, the control unit 90 switches the supply valve 32i from an open state to a closed state. That is, at the time point t2, the substantial drying liquid supply step ends.

In short, the substrate heating unit 40 does not heat the second main surface Wb of the substrate W during predetermined preceding time T1 from the time point t1 to the time point t12 in drying liquid supply time T from the time point t1 to the time point t2, and heats the second main surface Wb of the substrate W during predetermined subsequent time T2 from the time point t12 to the time point t2. The drying liquid supply time T is set to, for example, 20 seconds or more, and may be set to about 40 seconds as a specific example. The subsequent time T2 is preset to time during which temperature of the first main surface Wa of the substrate W at the time point t2 sufficiently approaches a boiling point of drying liquid. For example, the subsequent time T2 may be set to a half or less of the drying liquid supply time T, may be set to 1/3 or less, 1/4 or less, or 1/10 or less of the drying liquid supply time T.

As described above, in the third embodiment, the substrate heating unit 40 does not heat the substrate W during the preceding time T1, and heats the second main surface Wb of the substrate W during the subsequent time T2. That is, the substrate heating unit 40 heats the second main surface Wb of the substrate W only in the subsequent time T2. For this reason, operation time of the substrate heating unit 40 can be shortened, and power consumption of the substrate processing apparatus 100 can be reduced. Further, in a case where the substrate heating unit 40 supplies a high-temperature heat medium to the second main surface Wb of the substrate W, a supply amount of the heat medium can be reduced. In a case where the heat medium is liquid, a liquid-saving configuration can be achieved.

### <Fourth embodiment>

A configuration of the processing unit 1 according to a fourth embodiment is similar to that of the second embodiment, for example. In the fourth embodiment, in the drying liquid supply step (Step S5), the substrate heating unit 40 sets temperature of a heat medium to be equal to or higher than the boiling point bp of drying liquid.

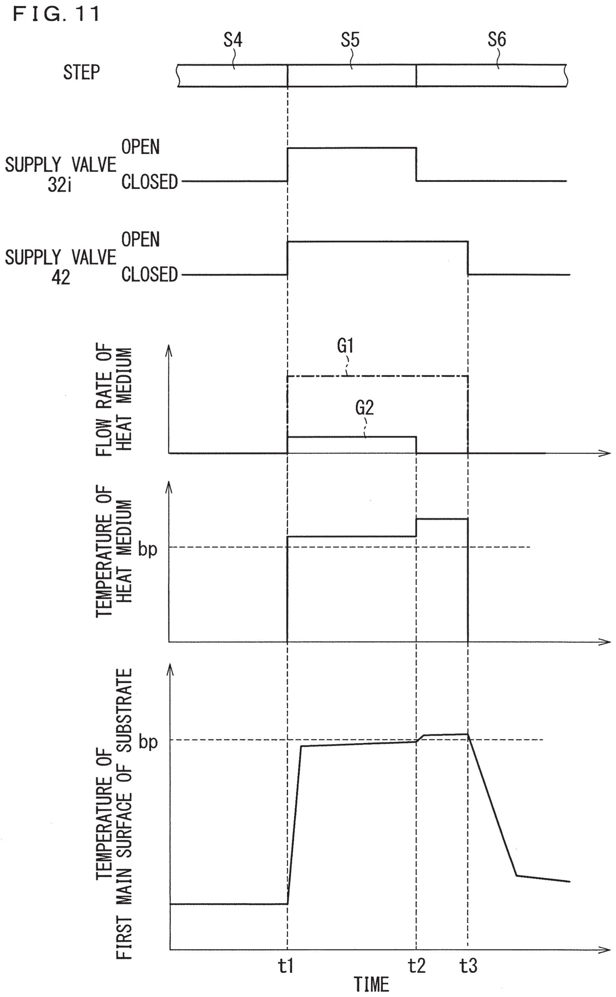

FIG. 11 is a diagram schematically illustrating an example of a timing chart of the processing unit 1 according to the fourth embodiment, a flow rate of a heat medium, temperature of the heat medium, and a temporal change of temperature of the first main surface Wa of the substrate W. In the example of FIG. 11, in the drying liquid supply step (Step S5), temperature of a heat medium dispensed from the nozzle 4 is higher than the boiling point bp of the drying liquid. In a case where the drying liquid is isopropyl alcohol, the boiling point bp is 82.4°C, and temperature of the heat medium is set to, for example, about 85°C. However, temperature of the heat medium may be set to a temperature below a boiling point of the heat medium. For example, in a case where the heat medium is water, the temperature may be set to less than 90 degrees Celsius that is 10 degrees lower than the boiling point (100 degrees Celsius). According to this, it is possible to comply with the SEMI standard.

In the drying liquid supply step, drying liquid having temperature lower than that of a heat medium is dispensed from the nozzle 3i. Low-temperature drying liquid continuously attached to the first main surface Wa of the substrate W can cool the first main surface Wa of the substrate W. Cooling capacity of the drying liquid increases as a flow rate of the drying liquid increases. In view of the above, a flow rate regulating valve 33i adjusts a flow rate of drying liquid to a value at which a substrate temperature of the first main surface Wa of the substrate W is less than the boiling point bp. Specifically, a flow rate of drying liquid is preset to, for example, about 250 ml/min or more. In the example of FIG. 11, temperature of a central portion of the first main surface Wa of the substrate W is illustrated as a substrate temperature. Since a high-temperature heat medium is attached to a central portion of the second main surface Wb of the substrate W, a substrate temperature of the substrate W has temperature distribution described below. That is, the substrate temperature is high at a central portion of the substrate W and decreases toward a radially outer side. For this reason, in the example of FIG. 11, a highest value in the temperature distribution of the first main surface Wa of the substrate W is shown as the substrate temperature.

As illustrated in FIG. 11, the substrate temperature in the drying liquid supply step is less than the boiling point bp of drying liquid. In a case where the drying liquid is isopropyl alcohol, a highest substrate temperature in temperature distribution of the substrate W may be adjusted to, for example, about 80°C or less. For this reason, boiling of the drying liquid in the drying liquid supply step can be more reliably suppressed. Thus, it is possible to more reliably suppress adhesion of particles to the first main surface Wa of the substrate W.

Moreover, in the fourth embodiment, temperature of a heat medium in the drying liquid supply step is the boiling point bp or more. For this reason, in the drying liquid supply step, a maximum value in temperature distribution of the first main surface Wa of the substrate W can be brought closer to the boiling point bp. A minimum value (that is, substrate temperature at a peripheral edge portion of the first main surface Wa) in temperature distribution of the first main surface Wa of the substrate W in the drying liquid supply step is, for example, 60°C or more. That is, a flow rate of drying liquid may be set such that substrate temperature of the first main surface Wa of the substrate W is 60°C or more and less than the boiling point bp of drying liquid.

In the fourth embodiment, even at the time of transition from the drying liquid supply step to the drying step, the nozzle 4 dispenses a heat medium at the boiling point bp or more to the second main surface Wb of the substrate W. For this reason, at a start time point of the drying step (that is, the time point t2), substrate temperature of the second main surface Wb of the substrate W can be set to a value closer to the boiling point bp of drying liquid. Therefore, temperature of the drying liquid at a start time point of the drying step can be further increased. That is, an evaporation rate of the drying liquid can be rapidly increased while a surface tension of the drying liquid can be rapidly reduced.

In the evaporation time in the drying step, substrate temperature of at least a part (for example, a central portion) of the first main surface Wa of the substrate W may be equal to or more than the boiling point bp of drying liquid. In the example of FIG. 11, substrate temperature (a maximum value) in the evaporation time is larger than the boiling point bp. That is, temperature and a flow rate of a heat medium are set so that the substrate temperature (maximum value) is equal to or more than the boiling point bp. According to this, an evaporation rate of drying liquid can be further increased while a surface tension of the drying liquid can be further reduced. Since substrate temperature decreases toward the peripheral edge side, temperature of at least a peripheral edge portion of a main surface of the substrate W is less than the boiling point bp of drying liquid. The drying liquid mainly flows outward on the first main surface Wa of the substrate W. That is, drying liquid mainly flows not in a state of floating from the first main surface Wa of the substrate W but in a state of being in contact with the first main surface Wa of the substrate W.

Note that also in the first to third embodiments, substrate temperature of at least a part (for example, a central portion) of the first main surface Wa of the substrate W during evaporation time may be equal to or more than the boiling point bp of drying liquid. That is, also in the first to third embodiments, temperature and a flow rate of a heat medium may be set such that substrate temperature (a maximum value) in evaporation time is the boiling point bp or more.

### <Fifth embodiment>

In the above example, the processing unit 1 performs the chemical liquid step (Step S3), the rinse step (Step S4), the drying liquid supply step (Step S5), and the drying step (Step S6) in this order. However, the present invention is not necessarily limited to this.

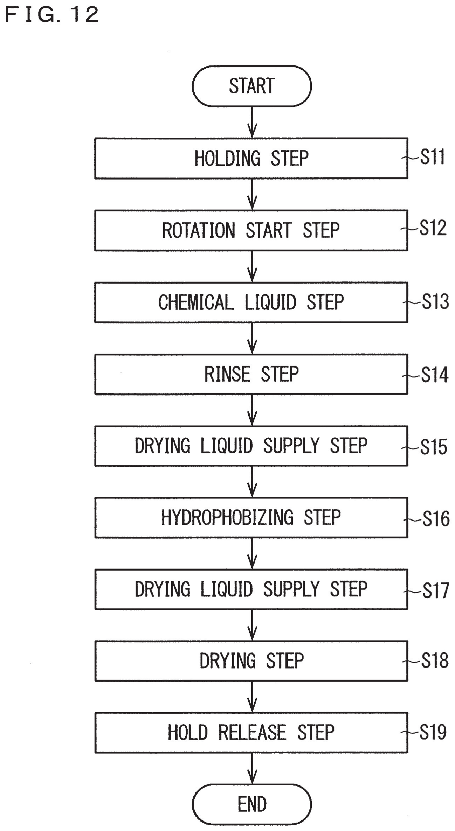

FIG. 12 is a flowchart illustrating a first example of an operation of the processing unit 1 according to a fifth embodiment. In the example of FIG. 12, the control unit 90 causes the processing unit 1 to execute processing of Steps S11 to S19 according to a preset processing procedure (recipe). Steps S11 to S15 are similar to Steps S1 to S5, respectively. However, in Step S15 (drying liquid supply step), the substrate heating unit 40 does not need to heat the substrate W.

Next, the processing unit 1 hydrophobizes the first main surface Wa of the substrate W (Step S16: hydrophobizing step: corresponding to the liquid supply step). Specifically, the processing unit 1 includes a nozzle that dispenses hydrophobization liquid, and causes the hydrophobization liquid to be dispensed from the nozzle to the first main surface Wa of the rotating substrate W. The hydrophobization liquid includes, for example, silicon-based hydrophobization liquid. The silicon-based hydrophobization liquid is hydrophobization liquid that hydrophobizes silicon (Si) itself and a compound containing silicon. The hydrophobization liquid is, for example, silylating liquid containing a liquid silylating agent (also referred to as a silane coupling agent). The processing unit 1 stops dispense of hydrophobization liquid from the nozzle when the first main surface Wa of the substrate W is sufficiently hydrophobized.

Next, the processing unit 1 executes Step S17 to Step S19. Steps S17 to S19 are similar to Steps S5 to S7, respectively.

As described above, also in the first example described above, drying step (Step S18) is executed similarly to the drying step (Step S6) in the first to fourth embodiments. For this reason, a collapse ratio of a pattern of the substrate W can be reduced. Moreover, since the first main surface Wa of the substrate W is hydrophobized, a contact angle of the first main surface Wa can be reduced. For this reason, a surface tension acting on a pattern can be reduced, and a collapse ratio of a pattern can be further reduced.

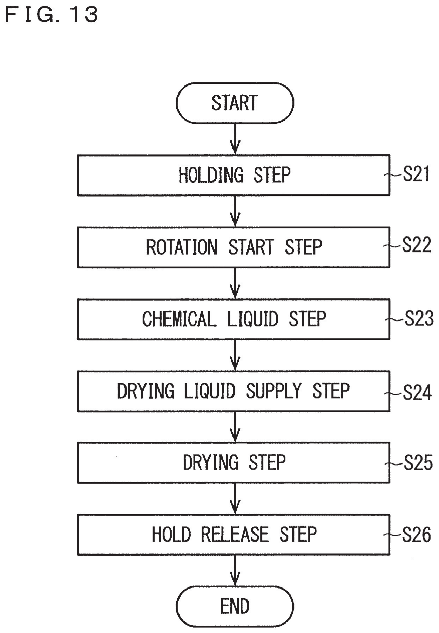

FIG. 13 is a flowchart illustrating a second example of an operation of the processing unit 1 according to the fifth embodiment. In the example of FIG. 13, the control unit 90 causes the processing unit 1 to execute processing of Steps S21 to S26 according to a preset processing procedure (recipe). Steps S21 to S26 are similar to Steps S1 to S3 and Steps S5 to S7, respectively. However, at an end time point of Step S23 (chemical liquid step: corresponding to the liquid supply step), metal is exposed on the first main surface Wa of the substrate W. According to the second example, after Step S23, Step S24 (the drying liquid supply step) is performed. For this reason, water is not supplied to the first main surface Wa of the substrate W. Therefore, a reaction between the metal and water can be avoided, and a failure due to the reaction can be avoided. Also in the second example described above, the drying step (Step S25) is performed similarly to the drying step (Step S6) in the first to fourth embodiments. For this reason, a collapse ratio of a pattern of the substrate W can be reduced.

### <Sixth embodiment>

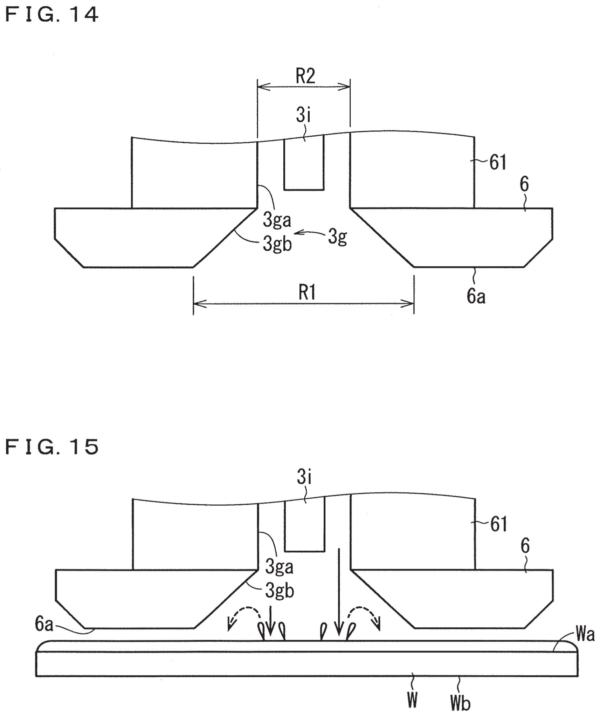

An example of a configuration of the substrate processing apparatus 100 according to a sixth embodiment is similar to that of the substrate processing apparatus 100 according to the first to fifth embodiments. However, a specific example of the shutoff plate 6 is different from the shutoff plate 6 according to the first to fifth embodiments. FIG. 14 is a diagram schematically illustrating a first example of a configuration of the shutoff plate 6 according to the sixth embodiment. Hereinafter, a lower surface of the shutoff plate 6 is referred to as a lower surface 6a. A lower end port (that is, a gas dispense port) of the gas flow path 3g is formed in a central portion of the lower surface 6a of the shutoff plate 6.

As illustrated in FIG. 14, the gas flow path 3g includes a vertical flow path 3ga and an enlarged diameter flow path 3gb. The vertical flow path 3ga is positioned vertically above the enlarged diameter flow path 3gb and extends along the vertical direction. In the example of FIG. 14, an inner peripheral surface of the hollow shaft 61 forms an outer peripheral surface of the vertical flow path 3ga. That is, the vertical flow path 3ga is located inside the hollow shaft 61. In the example of FIG. 14, a lower end port (that is, a dispense port) of the nozzle 3i is located above a lower end of the vertical flow path 3ga. Above the lower end port of the nozzle 3i, the vertical flow path 3ga corresponds to a tubular space between an inner peripheral surface of the hollow shaft 61 and an outer peripheral surface of the nozzle 3i. Below the lower end port of the nozzle 3i, the vertical flow path 3ga corresponds to a columnar space surrounded by an inner peripheral surface of the hollow shaft 61.

A lower end of the vertical flow path 3ga is connected to an upper end of the enlarged diameter flow path 3gb. Size in plan view of the lower end port of the enlarged diameter flow path 3gb (that is, the lower end port of the gas flow path 3g) is larger than size in plan view of the vertical flow path 3ga. Here, as an example, an inner peripheral surface of the hollow shaft 61 has a shape along a columnar side surface, and the lower end port of the enlarged diameter flow path 3gb has a circular shape. In this case, a diameter (outer diameter) R2 of the vertical flow path 3ga is smaller than a diameter R1 of the lower end port of the enlarged diameter flow path 3gb.

In the example of FIG. 14, a diameter of the enlarged diameter flow path 3gb increases toward the gas dispense port. The enlarged diameter flow path 3gb is formed by an inner peripheral surface of the shutoff plate 6, and the inner peripheral surface is an inclined surface. The inner peripheral surface of the shutoff plate 6 has, for example, a shape along a side surface of a conical frustum, and a lower end peripheral edge of the inner peripheral surface is connected to the lower surface 6a of the shutoff plate 6. The lower end peripheral edge forms a lower end port of the enlarged diameter flow path 3gb (that is, a gas dispense port).

Note that as illustrated in FIG. 14, a diameter of the enlarged diameter flow path 3gb may monotonically increase toward the lower surface 6a of the shutoff plate 6. Alternatively, a diameter of the enlarged diameter flow path 3gb may increase stepwise (that is, in a staircase-like manner) toward the lower surface 6a of the shutoff plate 6.

Also in the sixth embodiment, inert gas is dispensed from the lower end port of the gas flow path 3g toward the first main surface Wa of the substrate W. FIG. 15 is a diagram schematically illustrating an example of a state in which inert gas is dispensed. When inert gas is dispensed toward the first main surface Wa of the substrate W, the inert gas collides with a liquid film of drying liquid on the first main surface Wa of the substrate W. This collision may cause the drying liquid to splash. In the sixth embodiment, since the lower end port of the gas flow path 3g is large, splashed drying liquid hardly reaches the lower surface 6a of the shutoff plate 6.

A specific example of an operation of the processing unit 1 of the sixth embodiment may be similar to or different from an operation of the processing unit 1 according to the first to fifth embodiments. As an example, the processing unit 1 of the sixth embodiment operates along the flowchart of FIG. 4.

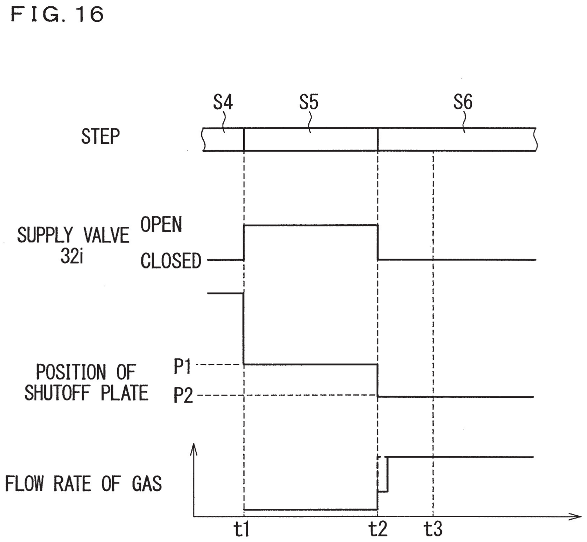

FIG. 16 is a diagram illustrating a first example of a timing chart of the processing unit 1 according to the sixth embodiment. The example of FIG. 16 illustrates an example of a temporal change in a position of the shutoff plate 6 and a temporal change in a flow rate of inert gas. In the example of FIG. 16, as in the first to fifth embodiments, the movement drive unit 35i moves the shutoff plate 6 from a shutoff processing position P1 to a drying position P2 when supply of drying liquid is stopped (the time point t2). In the sixth embodiment, the gas flow path 3g of the shutoff plate 6 has the enlarged diameter flow path 3gb. Therefore, as described above, even when the shutoff plate 6 is moved to a position closer to the first main surface Wa of the substrate W, drying liquid can be prevented from adhering to the shutoff plate 6. For example, the drying position may be set at a position where an interval between the lower surface 6a of the shutoff plate 6 and the first main surface Wa of the substrate W is 2 mm or less, or may be set at a position where the interval is 1 mm or less.

Then, by narrowing the interval, the processing unit 1 can more quickly dry the substrate W. That is, since the interval can be set to be narrow from an initial stage of the drying step, the processing unit 1 can dry the substrate W with high drying performance from the initial stage of the drying step. In particular, drying performance at an initial stage of the drying step strongly affects suppression of collapse of a pattern. For this reason, the processing unit 1 can further reduce a collapse ratio of a pattern.

As illustrated in FIG. 16, the processing unit 1 may supply inert gas to the first main surface Wa of the substrate W in the drying liquid supply step (Step S5). That is, the control unit 90 may open the supply valve 32g in the drying liquid supply step. By this, also in the drying liquid supply step, inert gas is dispensed from the lower end port of the gas flow path 3g. By this, it is possible to prevent a volatile component of drying liquid from staying in a space between the shutoff plate 6 and the substrate W. A flow rate of inert gas in the drying liquid supply step is set to, for example, 20 mL (milliliters)/min or less.

In the example of FIG. 16, the processing unit 1 increases a flow rate of inert gas when the shutoff plate 6 is moved to the drying position P2 in the drying step. For example, the flow rate regulating valve 33g may increase a flow rate of inert gas from a value of 20 mL (milliliters)/min or less to a value of 30 mL/min or more. In the example of FIG. 16, the flow rate regulating valve 33g increases a flow rate of inert gas stepwise with lapse of time. As a final flow rate of inert gas in the drying step, the flow rate regulating valve 33g may increase the flow rate to 100 mL/min or more. The processing unit 1 may increase the flow rate to 150 mL/min or more, or 200 mL/min or more.

As described above, the processing unit 1 increases a flow rate of inert gas as the shutoff plate 6 is lowered to the drying position P2. For this reason, the processing unit 1 can dry the substrate W with high drying performance from an initial stage of the drying step. Moreover, in the sixth embodiment, since the gas flow path 3g has the enlarged diameter flow path 3gb, a liquid splash is less likely to reach the shutoff plate 6 even if a flow rate of inert gas is increased and a liquid splash is likely to occur. For this reason, adhesion of drying liquid to the shutoff plate 6 can also be suppressed.

Note that the flow rate regulating valve 33g may increase a flow rate of inert gas not stepwise but in stages. That is, the flow rate regulating valve 33g may increase a flow rate of inert gas to a final value at the time point t2. As described above, even if inert gas is supplied at a high flow rate from an initial stage of the drying step, since the gas flow path 3g has the enlarged diameter flow path 3gb, a liquid splash hardly reaches the shutoff plate 6. Then, when the processing unit 1 supplies inert gas at a high flow rate from an initial stage of the drying step, drying performance can be further improved. For this reason, the processing unit 1 can further reduce a collapse ratio of a pattern.

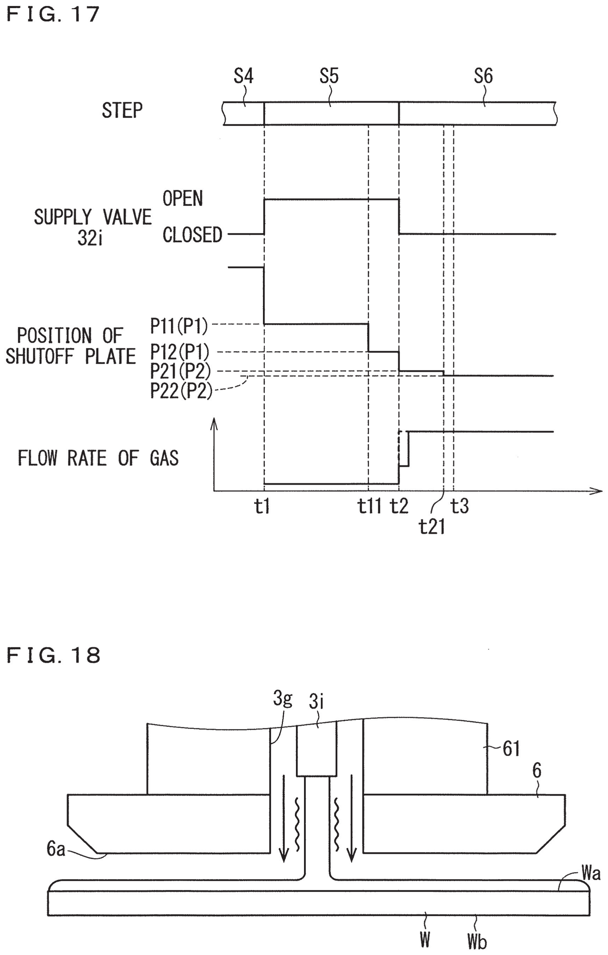

FIG. 17 is a diagram schematically illustrating a second example of the timing chart of the processing unit 1 according to the sixth embodiment. In the example of FIG. 17, at a time point t11 in the middle of the drying liquid supply step, the control unit 90 causes the movement drive unit 35i to lower the shutoff plate 6. Specifically, in the example of FIG. 17, the shutoff plate 6 is located at a first shutoff processing position P11 in an initial stage of the drying liquid supply step. Then, at the time point t11, the movement drive unit 35i moves the shutoff plate 6 from the first shutoff processing position P11 to a second shutoff processing position P12. The second shutoff processing position P12 is closer to the first main surface Wa of the substrate W than the first shutoff processing position P11, and is farther from the first main surface Wa of the substrate W than the drying position P2 (in the diagram, a first drying position P21). That is, the second shutoff processing position P12 is a position between the first shutoff processing position P11 and the drying position P2. Each of the first shutoff processing position P11 and the second shutoff processing position P12 is an example of the shutoff processing position P1. For example, the second shutoff processing position P12 may be set at a position where an interval between the shutoff plate 6 and the substrate W is 10 mm or less, or may be set at a position where the interval is about 5 mm. For example, the first shutoff processing position P11 may be set at a position where an interval between the shutoff plate 6 and the substrate W is 20 mm or more (for example, about 30 mm).

As described above, in the example of FIG. 17, in the drying liquid supply step, the processing unit 1 supplies drying liquid to the first main surface Wa of the substrate W in a state where the shutoff plate 6 is located at the first shutoff processing position P11, and then moves the shutoff plate 6 to the second shutoff processing position P12 while supplying drying liquid.

Here, a case where the gas flow path 3g extends in a columnar shape will be described. FIG. 18 is a diagram illustrating an example of a state of the processing unit 1 in the drying liquid supply step. Here, the shutoff plate 6 is located at the second shutoff processing position P12. In the example of FIG. 18, an outlet portion of the gas flow path 3g below the dispense port of the nozzle 3i extends along the vertical direction with an equal width. Inert gas flows in a space between drying liquid as a liquid column from the dispense port of the nozzle 3i and an inner peripheral surface of the shutoff plate 6 at the outlet portion, and then flows in a space between the lower surface 6a of the shutoff plate 6 and the first main surface Wa of the substrate W. Since the outlet portion of the gas flow path 3g extends in the vertical direction with an equal width, volume of the space is relatively small. Further, in a case where the shutoff plate 6 is located at the second shutoff processing position P12, volume of a space between the shutoff plate 6 and the substrate W is also relatively small. For this reason, a flow path cross section of inert gas is small. Therefore, pressure of inert gas increases, and drying liquid as a liquid column is easily affected by a flow of inert gas. As a result, drying liquid as a liquid column may oscillate. In FIG. 18, an oscillation of drying liquid as a liquid column is schematically indicated by a wavy line. Due to such an oscillation of drying liquid, a liquid attachment position on the first main surface Wa of the substrate W may oscillate, or droplets may scatter from drying liquid as a liquid column and adhere to the shutoff plate 6.

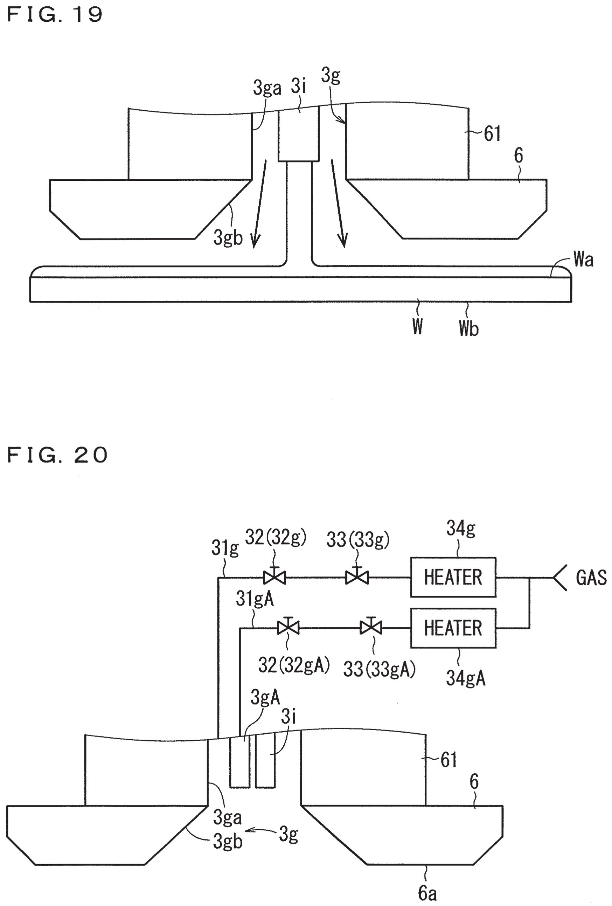

FIG. 19 is a diagram illustrating an example of a state of the processing unit 1 in the drying liquid supply step according to the sixth embodiment. In the example of FIG. 19, the gas flow path 3g has the enlarged diameter flow path 3gb. For this reason, volume of a space between drying liquid as a liquid column from the nozzle 3i and an inner peripheral surface of the shutoff plate 6 is relatively large. For this reason, inert gas can flow at a position relatively away from drying liquid as a liquid column, and influence of a flow of the inert gas on the drying liquid can be reduced. Therefore, an oscillation of drying liquid as a liquid column can be reduced.

In the above example, in the last period of the drying liquid supply step (Step S5), the shutoff plate 6 is located at the second shutoff processing position P12 closer to the drying position P2. For this reason, in the next drying step (Step S6), a moving distance of the shutoff plate 6 can be shortened. That is, in an initial stage of the drying step, the shutoff plate 6 only needs to move from the second shutoff processing position P12 to the drying position P2, and can reach the drying position P2 by a shorter moving distance than a moving distance from the first shutoff processing position P11 to the drying position P2. For this reason, the movement drive unit 35i can cause the shutoff plate 6 to reach the drying position P2 at an earlier timing. Therefore, drying performance at an initial stage of the drying step can be further improved.

Note that the time point t11 at which the shutoff plate 6 starts to move toward the second shutoff processing position P12 may be, for example, later than a central time point during the drying liquid supply time for supplying drying liquid. That is, a time difference between the time point t11 and the time point t2 may be shorter than a time difference between the time point t1 and the time point t11.

In the example of FIG. 17, at a time point t21 in the middle of the drying step, the control unit 90 causes the movement drive unit 35i to move the shutoff plate 6 from the first drying position P21 to a second drying position P22. The second drying position P22 is a position closer to the first main surface Wa of the substrate W than the first drying position P21. The second drying position P22 may be a position where a distance from the first main surface Wa of the substrate W is 0.5 mm or less. Each of the first drying position P21 and the second drying position P22 is an example of the drying position P2. The time point t21 at which the shutoff plate 6 starts to move to the second drying position P22 may be, for example, after a time point at which scattering of drying liquid from a peripheral edge of the substrate W substantially ends. That is, the shutoff plate 6 is lowered to the second drying position P22 after drying liquid above a pattern of the substrate W is substantially shaken off to the outside. By this, drying liquid in a pattern of the substrate W can be evaporated in a state where the shutoff plate 6 is located at the second drying position P22, and the substrate W can be dried more quickly. The control unit 90 may cause the movement drive unit 35i to move the shutoff plate 6 to the second drying position P22 when preset time elapses from the time point t2. The time is set to time sufficient for substantially ending scattering of drying liquid from the substrate W.

FIG. 20 is a diagram illustrating a second example of the configuration of the shutoff plate 6 according to the sixth embodiment. In the second example, a gas nozzle 3gA is provided. Similarly to the nozzle 3i, the gas nozzle 3gA is provided inside the hollow shaft 61. The gas nozzle 3gA is adjacent in the horizontal direction. The gas nozzle 3gA extends along the vertical direction, and a lower end port of the gas nozzle 3gA functions as a gas dispense port. An upstream end of the gas nozzle 3gA is connected to a downstream end of a supply pipe 31gA. An upstream end of the supply pipe 31gA is connected to a gas supply source.

The supply pipe 31gA is provided with a supply valve 32gA, a flow rate regulating valve 33gA, and a heater 34gA. The supply valve 32gA switches the supply pipe 31gA between open and closed states. The flow rate regulating valve 33gA adjusts a flow rate of inert gas flowing through the supply pipe 31gA. The heater 34gA heats inert gas flowing through the supply pipe 31gA. The heater 34gA may be, for example, an electric resistance type heater having an electric heating wire. The supply valve 32gA, the flow rate regulating valve 33gA, and the heater 34gA are controlled by the control unit 90.

In the drying liquid supply step (Step S5), the control unit 90 may open the supply valve 32g and close the supply valve 32gA. By this, in the drying liquid supply step, inert gas is not dispensed from the gas nozzle 3gA, and the inert gas is dispensed from the gas flow path 3g. Since inert gas is not dispensed from the gas nozzle 3gA provided at a position close to the nozzle 3i, it is possible to suppress an oscillation of drying liquid as a liquid column caused by inert gas. On the other hand, in the drying step (Step S6), the control unit 90 opens the supply valve 32g and the supply valve 32gA. By this, in the drying step, inert gas is dispensed from the gas flow path 3g and the gas nozzle 3gA. For this reason, inert gas can be more appropriately supplied to a central portion of the substrate W. A value of a flow rate of inert gas described above may be the sum of flow rates of inert gas flowing through the gas flow path 3g and the gas nozzle 3gA.

As described above, the substrate processing apparatus 100 and the substrate processing method are described in detail, but the above description is an example in all aspects, and the present disclosure is not limited to this. Further, the various modification examples described above can be applied in combination as long as they do not contradict each other. Then, it is understood that a large number of variations that are not exemplified are conceivable without departing from the scope of the present disclosure.

In the above-described example, a dedicated nozzle is provided for each fluid, but one nozzle may be shared by different types of fluids.

Further, in the above example, the substrate heating unit 40 supplies a heat medium to the second main surface Wb of the substrate W, but the present invention is not necessarily limited to this. The substrate heating unit 40 may include, for example, a heater provided at a position facing the second main surface Wb of the substrate W in the vertical direction. The heater may be, for example, an electric resistance type heater including an electric heating wire, or may be an optical type heater that outputs light for heating.

Further, in the above example, the substrate heating unit 40 heats the second main surface Wb of the substrate W in the evaporation time from the time point t2 at which supply of drying liquid is stopped to the time point t3. However, the substrate heating unit 40 may interrupt heating during partial interruption time during the evaporation time.

### EXPLANATION OF REFERENCE SIGNS

3g: gas flow path
3gb: enlarged diameter flow path
6: shutoff plate
P1: shutoff processing position
P11: first shutoff processing position
P12: second shutoff processing position
P2: drying position
P21: first drying position
P22: second drying position
S1, S11, S21: holding step
S4, S16, S23: liquid supply step
S5, S17, S24: drying liquid supply step
S6, S18, S25: drying step
T2: subsequent time
W: substrate
Wa: first main surface
Wb: second main surface

## Claims

1. A substrate processing method comprising:
a holding step of holding a substrate having a first main surface on which a pattern is formed and a second main surface on a side opposite to said first main surface;
a liquid supply step of supplying process liquid to said first main surface of said substrate;
a drying liquid supply step of supplying drying liquid to said first main surface of said substrate after said liquid supply step; and
a drying step of heating said second main surface of said substrate in a predetermined period after said drying liquid supply step to set a substrate temperature of said first main surface of said substrate to be equal to or more than said substrate temperature in said drying liquid supply step, and drying said substrate.

2. The substrate processing method according to claim 1, wherein
during said predetermined period, said substrate temperature of at least a part of said first main surface of said substrate is equal to or more than a boiling point of said drying liquid.

3. The substrate processing method according to claim 1 or 2, wherein
in said drying liquid supply step, said second main surface of said substrate is heated with a first amount of heat per unit time, and
during said predetermined period in said drying step, said second main surface of said substrate is heated with a second amount of heat per unit time larger than said first amount of heat.

4. The substrate processing method according to claim 1 or 2, wherein
during said predetermined period, a heat medium is supplied to said second main surface of said substrate.

5. The substrate processing method according to claim 3, wherein
in said drying liquid supply step, a heat medium obtained by mixing a high-temperature heat medium and a low-temperature heat medium having a temperature lower than a temperature of said high-temperature heat medium is supplied to said second main surface of said substrate, and
a mixing ratio of said high-temperature heat medium and said low-temperature heat medium is adjusted to supply said heat medium having a higher temperature than said heat medium in said drying liquid supply step to said second main surface of said substrate at least during said predetermined period in said drying step.

6. The substrate processing method according to claim 4, wherein
during said predetermined period, said heat medium having a temperature equal to or more than a boiling point of said drying liquid is supplied to said second main surface of said substrate.

7. The substrate processing method according to claim 4, wherein
in said drying liquid supply step, while said heat medium having a temperature equal to or more than a boiling point of said drying liquid is supplied to said second main surface of said substrate, said drying liquid is supplied at a flow rate at which said substrate temperature of said first main surface of said substrate is less than said boiling point.

8. The substrate processing method according to claim 4, wherein
said heat medium includes liquid,
in said drying liquid supply step, said drying liquid is supplied to said first main surface of said substrate in a state in which a shutoff plate having a facing surface facing said first main surface of said substrate is located at a shutoff processing position, and
during said predetermined period in said drying step, in a state where said shutoff plate is moved to a drying position closer to said first main surface than said shutoff processing position, inert gas is supplied from a gas dispense port at a central portion of said shutoff plate toward said first main surface of said substrate.

9. The substrate processing method according to claim 8, wherein
during said predetermined period, said heated inert gas is supplied to said first main surface of said substrate.

10. The substrate processing method according to claim 8, wherein
in said drying liquid supply step, said inert gas is supplied to said first main surface of said substrate through a gas flow path inside said shutoff plate having an enlarged diameter flow path spreading toward said gas dispense port, and
a flow rate of said inert gas is increased while said shutoff plate is moved from said shutoff processing position to said drying position.

11. The substrate processing method according to claim 10, wherein
in said drying liquid supply step, said drying liquid is supplied to said first main surface of said substrate in a state where said shutoff plate is located at a first shutoff processing position which is one of said shutoff processing positions, and then said shutoff plate is moved to a second shutoff processing position which is one of said shutoff processing positions and closer to said first main surface of said substrate than said first shutoff processing position while said drying liquid is supplied.

12. The substrate processing method according to claim 1 or 2, wherein
during said predetermined period in said drying step, said substrate is rotated at a rotation speed higher than a rotation speed of said substrate in said drying liquid supply step.

13. The substrate processing method according to claim 1 or 2, wherein
in said drying liquid supply step, said second main surface of said substrate is heated only in subsequent time during drying liquid supply time for supplying said drying liquid.
